# EUROPEAN PATENT APPLICATION

(11) **EP 4 586 049 A1**
(43) Date of publication of application: **16.07.2025**
(21) Application number: 24219005.6
(22) Date of filing: 11.12.2024
(51) Int. Cl.: G06F 1/16, G09F 9/30, H04M 1/02, H10K 77/10

(54) **DISPLAY DEVICE**

(30) Priority: 09.01.2024 KR 20240003748
(71) Applicant: Samsung Display Co., Ltd., Gyeonggi-Do (KR)
(72) Inventor: LEE, Yonghyuck, Yongin-si (KR); YANG, Seungyo, Yongin-si (KR); EO, Sungwoo, Yongin-si (KR)
(74) Representative: Marks & Clerk LLP

(57) **Abstract**

A display device includes: a display panel comprising a first non-folding area, a folding area, and a second non-folding area, arranged in a first direction; a support plate under the display panel and having a plurality of openings that overlaps the folding area; an upper adhesive layer between the display panel and the support plate and overlapping the openings; and a cover layer overlapping the openings and under the support plate, the support plate including: a plurality of supporters between the openings adjacent to each other in the first direction; and a plurality of branches between the openings adjacent to each other in a second direction intersecting the first direction, wherein the openings are defined by the branches and the supporters, and at least one of a lower surface of the branches or a lower surface of the supporters is provided with a plurality of air grooves defined therein.

## Description

### BACKGROUND

### 1. Field

Aspects of some embodiments of the present disclosure relate to a display device.

### 2. Description of Related Art

Electronic devices that provide images to a user, such as a smart phone, a digital camera, a notebook computer, a navigation unit, and a smart television, include a display device to display the images. The display device generates the images and provides the images to the user through a display screen thereof.

In recent years, with the technological development for the display device, various types of display devices are being developed. For example, various display devices, which are capable of being transformed into a curved shape, foldable, or rollable, are being developed. Those display devices may be relatively easy to carry and may improve a user's convenience.

A flexible display device typically includes a flexible display panel and a support plate located under the flexible display panel. The support plate may be provided with a plurality of openings defined therethrough. The display device may typically include cover layers to prevent a foreign material from entering the openings.

The above information disclosed in this Background section is only for enhancement of understanding of the background and therefore the information discussed in this Background section does not necessarily constitute prior art.

### SUMMARY

Aspects of at least some embodiments of the present disclosure include a display device that may be capable of preventing or reducing openings defined through a support plate from being viewed from outside.

Aspects of some embodiments of the present disclosure include a display device including a display panel including a first non-folding area, a folding area, and a second non-folding area, which are arranged in a first direction, a support plate under the display panel and provided with a plurality of openings that overlaps the folding area, an upper adhesive layer between the display panel and the support plate and overlapping the openings, and a cover layer overlapping the openings and under the support plate, and the support plate includes a plurality of supporters between the openings adjacent to each other in the first direction and a plurality of branches between the openings adjacent to each other in a second direction intersecting the first direction, and the openings are defined by the branches and the supporters, and at least one of a lower surface of the branches or a lower surface of the supporters is provided with a plurality of air grooves defined therein.

Aspects of some embodiments of the present disclosure include a display device including a display panel, a support plate under the display panel and including a first non-folding portion, a folding portion, and a second non-folding portion, which are arranged in a first direction, an upper adhesive layer between the display panel and the folding portion, and a cover layer on a lower surface of the folding portion, and the folding portion includes a curved portion through which a plurality of openings arranged in the first direction and a second direction intersecting the first direction is defined, a first flat portion between the first non-folding portion and the curved portion, and a second flat portion between the second non-folding portion and the curved portion, and the cover layer is on a lower surface of the first and second flat portions, and a height of a lower surface of the curved portion is greater than a height of the lower surface of the first and second flat portions.

In at least some embodiments, the air grooves are defined in a lower surface of the support plate. In one or more embodiments, external air may flow through the air grooves and is filled inside the openings. Thus, in at least some embodiments, the openings are prevented from being in a vacuum state, and the upper adhesive layer and the cover layer are prevented or mitigated from being deformed to correspond to a pattern of the openings. Accordingly, the pattern of the openings cannot be viewed from the outside.

At least some of the above and other features of the invention are set out in the claims.

### BRIEF DESCRIPTION OF THE DRAWINGS

The above and other advantages of the present disclosure will become readily apparent by reference to the following detailed description when considered in conjunction with the accompanying drawings wherein:
FIG. 1 is a perspective view of an electronic device according to some embodiments of the present disclosure;
FIGS. 2A and 2B are perspective views of a folded state of the electronic device shown in FIG. 1;
FIG. 3 is an exploded perspective view of the electronic device shown in FIG. 1;
FIG. 4 is a block diagram of the electronic device shown in FIG. 3;
FIG. 5 is a cross-sectional view of a display module shown in FIG. 3;
FIG. 6 is a cross-sectional view of a display panel shown in FIG. 5;
FIG. 7 is a plan view of a display panel shown in FIG. 3;
FIG. 8 is a cross-sectional view of an electronic panel corresponding to one pixel shown in FIG. 7;
FIG. 9A is a cross-sectional view taken along a line I-I' of FIG. 7;
FIG. 9B is a view showing a bent state of a bending area of FIG. 9A;
FIG. 10A is a perspective view of a support plate shown in FIG. 9A;
FIG. 10B is an enlarged view of a first area shown in FIG. 10A;
FIG. 10C is a perspective view of the support plate shown in FIG. 10A turned upside down;
FIGS. 11A and 11B are views illustrating a folding operation of a window module, a display module, and a support plate of FIG. 9A according to some embodiments of the present disclosure;
FIG. 12A is a plan view of a second area shown in FIG. 10A;
FIG. 12B is a view illustrating a curved portion according to some embodiments of the present disclosure;
FIGS. 13A and 13B are views of a third area of a curved portion shown in FIG. 10C;
FIGS. 13C and 13D are views illustrating a curved portion according to embodiments of the present disclosure;
FIGS. 14A to 14C are views illustrating air grooves according to embodiments of the present disclosure;
FIGS. 15A and 15B are views illustrating air grooves according to some embodiments of the present disclosure;
FIGS. 16A to 16C are views illustrating air grooves according to embodiments of the present disclosure;
FIGS. 17A and 17B are views illustrating air grooves according to embodiments of the present disclosure;
FIGS. 18A to 18D are views illustrating branches and supporters according to embodiments of the present disclosure;
FIGS. 19A and 19B are views illustrating supporters according to embodiments of the present disclosure;
FIG. 20 is a view illustrating air grooves according to some embodiments of the present disclosure; and
FIGS. 21A and 21B are views illustrating a curved portion according to embodiments of the present disclosure.

### DETAILED DESCRIPTION

Features of the inventive concept and methods of accomplishing the same may be understood more readily by reference to the following detailed description of example embodiments and the accompanying drawings. The inventive concept may, however, be embodied in many different forms and should not be construed as being limited to the embodiments set forth herein. Rather, these embodiments are provided so that this disclosure will be through and complete and will fully convey the inventive concept to those skilled in the art, and the inventive concept will only be defined by the appended claims. Like reference numerals denote like elements throughout the specification.

In the present disclosure, it will be understood that when an element or layer is referred to as being "on", "connected to" or "coupled to" another element or layer, it can be directly on, connected or coupled to the other element or layer or intervening elements or layers may be present. In contrast, when an element is referred to as being "directly on," "directly connected to" or "directly coupled to" another element or layer, there are no intervening elements or layers present. As used herein, the term "and/or" includes any and all combinations of one or more of the associated listed items.

Spatially relative terms, such as "beneath", "below", "lower", "above", "upper" and the like, may be used herein for ease of description to describe one element or feature's relationship to another element(s) or feature(s) as illustrated in the figures. It will be understood that the spatially relative terms are intended to encompass different orientations of the device in use or operation in addition to the orientation depicted in the figures.

It will be understood that, although the terms first, second, etc. may be used herein to describe various elements, components, regions, layers and/or sections, these elements, components, regions, layers and/or sections should not be limited by these terms. These terms are only used to distinguish one element, component, region, layer or section from another region, layer or section. Thus, a first element, component, region, layer or section discussed below could be termed a second element, component, region, layer or section without departing from the teachings of the present disclosure.

Embodiments described in the disclosure are described with reference to plan views and cross-sectional views that are ideal schematic diagrams. Accordingly, shapes of the views may vary depending on manufacturing technologies and/or tolerances. Thus, embodiments are not limited to shown specific forms and also include variations in form produced according to manufacturing processes. Therefore, regions illustrated in the drawings are merely examples, and the shapes of the regions illustrated in the drawings are intended to illustrate the specific shapes of the regions of elements and not to limit the scope of the present disclosure.

Hereinafter, embodiments of the present disclosure will be described with reference to accompanying drawings.

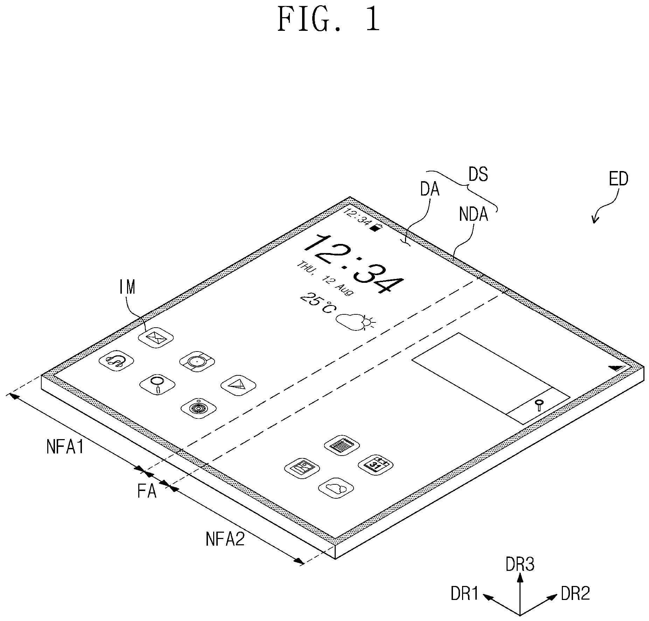

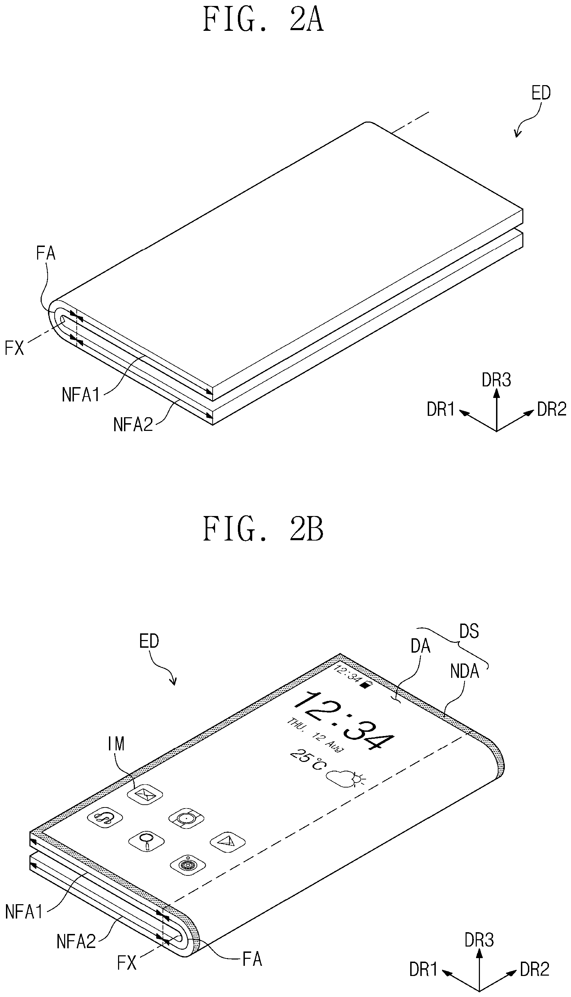

FIG. 1 is a perspective view of an electronic device ED according to some embodiments of the present disclosure. FIGS. 2A and 2B are perspective views of a folded state of the electronic device ED shown in FIG. 1.

Referring to FIG. 1, the electronic device ED may have a rectangular shape defined by short sides extending in a first direction DR1 and long sides extending in a second direction DR2 intersecting the first direction DR1. However, the shape of the electronic device ED should not be limited to the rectangular shape, and the electronic device ED may have various shapes, such as a circular shape and another polygonal shape. The electronic device ED may be flexible.

Hereinafter, a direction perpendicular (or substantially perpendicular) to a plane defined by the first direction DR1 and the second direction DR2 may be referred to as a third direction DR3. In the present disclosure, the expressions "when viewed in a plane" or "in a plan view" may refer to a state of being viewed from the third direction DR3.

The electronic device ED may include a folding area FA and a plurality of non-folding areas NFA1 and NFA2. The non-folding areas NFA1 and NFA2 may include a first non-folding area NFA1 and a second non-folding area NFA2. The folding area FA may be located between the first non-folding area NFA1 and the second non-folding area NFA2. The first non-folding area NFA1, the folding area FA, and the second non-folding area NFA2 may be arranged in the first direction DR1.

In the present embodiments, one folding area FA and two non-folding areas NFA1 and NFA2 are shown as a representative example, however, the number of the folding areas FA and the number of the non-folding areas NFA1 and NFA2 should not be limited thereto or thereby. For example, the electronic device ED may include more than two non-folding areas and a plurality of folding areas located between the non-folding areas.

An upper surface of the electronic device ED may be referred to as a display surface DS, and the display surface DS may include a plane defined by the first direction DR1 and the second direction DR2. Images IM generated by the electronic device ED may be provided to a user through the display surface DS.

The display surface DS may include a display area DA and a non-display area NDA around the display area DA. The display area DA may display the image IM, and the non-display area NDA may not display the image IM. The non-display area NDA may surround the display area DA and may define an edge of the electronic device ED, which is printed in a predetermined color.

Referring to FIGS. 2A and 2B, the electronic device ED may be a foldable electronic device ED that can be folded or unfolded. As an example, the folding area FA may be folded with respect to a folding axis FX parallel (or substantially parallel) to the second direction DR2, and thus, the electronic device ED may be folded. The folding axis FX may be defined as a major axis parallel (or substantially parallel) to the long sides of the electronic device ED. When the electronic device ED is folded, the first non-folding area NFA1 and the second non-folding area NFA2 may face each other, and the display surface DS may not be exposed to the outside, that is, the electronic device ED may be inwardly folded (in-folding). However, the present disclosure should not be limited thereto or thereby. As an example, the electronic device ED may be outwardly folded (out-folding) with respect to the folding axis FX such that the display surface DS may be exposed to the outside as shown in FIG. 2B. According to some embodiments, the electronic device ED may be capable of both being in-folded and out-folded.

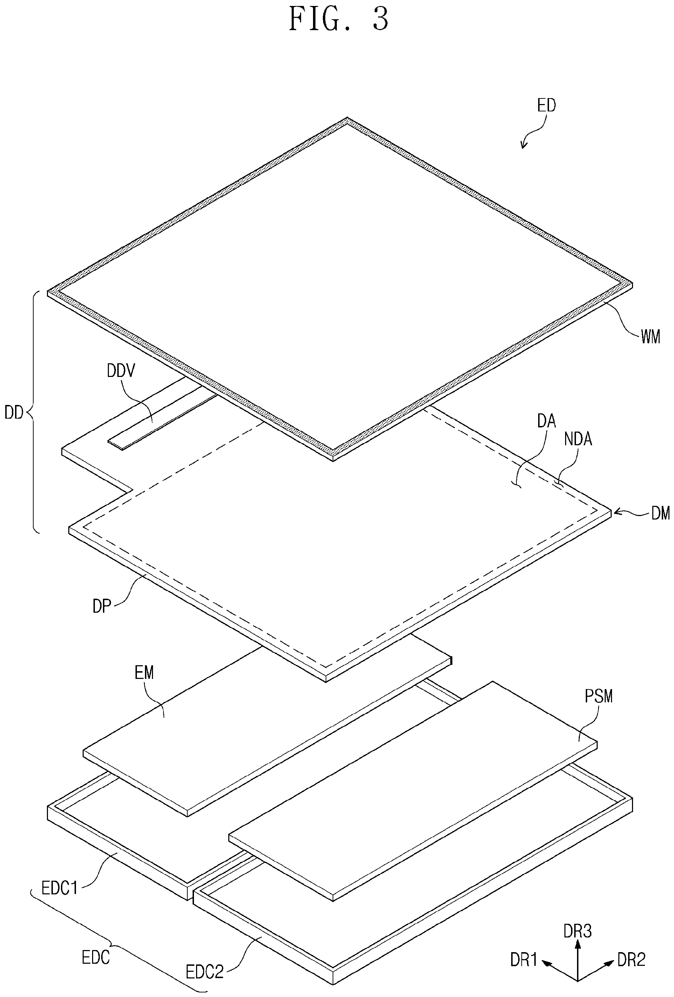

FIG. 3 is an exploded perspective view of the electronic device ED shown in FIG. 1.

Referring to FIG. 3, the electronic device ED may include a display device DD, an electronic module EM, a power module PSM, and a case EDC. According to some embodiments, the electronic device ED may further include a mechanical structure, e.g., a hinge structure, to control a folding operation of the display device DD.

The display device DD may generate an image IM and may sense an external input. The display device DD may include a window module WM and a display module DM. The window module WM may provide a front surface of the electronic device ED. The window module WM may be located on the display module DM and may protect the display module DM. The window module WM may transmit a light generated by the display module DM to provide the light to a user.

The display module DM may include a display panel DP. FIG. 3 shows only the display panel DP among components of the display module DM, however, the display module DM may further include a plurality of components located on and under the display panel DP. The detailed stack structure of the display module DM will be described later. The display panel DP may include a display area DA and a non-display area NDA, which respectively correspond to the display area DA (refer to FIG. 1) and the non-display area NDA (refer to FIG. 1) of the electronic device ED.

The display module DM may include a data driver DDV located in the non-display area NDA of the display panel DP. The data driver DDV may be manufactured in an integrated circuit chip form and may be mounted in the non-display area NDA, however, it should not be limited thereto or thereby. According to some embodiments, the data driver DDV may be mounted on a flexible circuit board connected to the display panel DP.

The electronic module EM and the power module PSM may be located under the display device DD. According to some embodiments, the electronic module EM and the power module PSM may be connected to each other via a separate flexible circuit board. The electronic module EM may control an operation of the display device DD. The power module PSM may supply a power to the electronic module EM.

The case EDC may accommodate the display device DD, the electronic module EM, and the power module PSM. The case EDC may include two cases, e.g., first and second cases EDC1 and EDC2, to fold the display device DD. The first and second cases EDC1 and EDC2 may extend in the second direction DR2 and may be arranged in the first direction DR1.

According to some embodiments, the electronic device ED may further include a hinge structure to connect the first and second cases EDC1 and EDC2. The case EDC may be coupled to the window module WM. The case EDC may protect the display device DD, the electronic module EM, and the power module PSM.

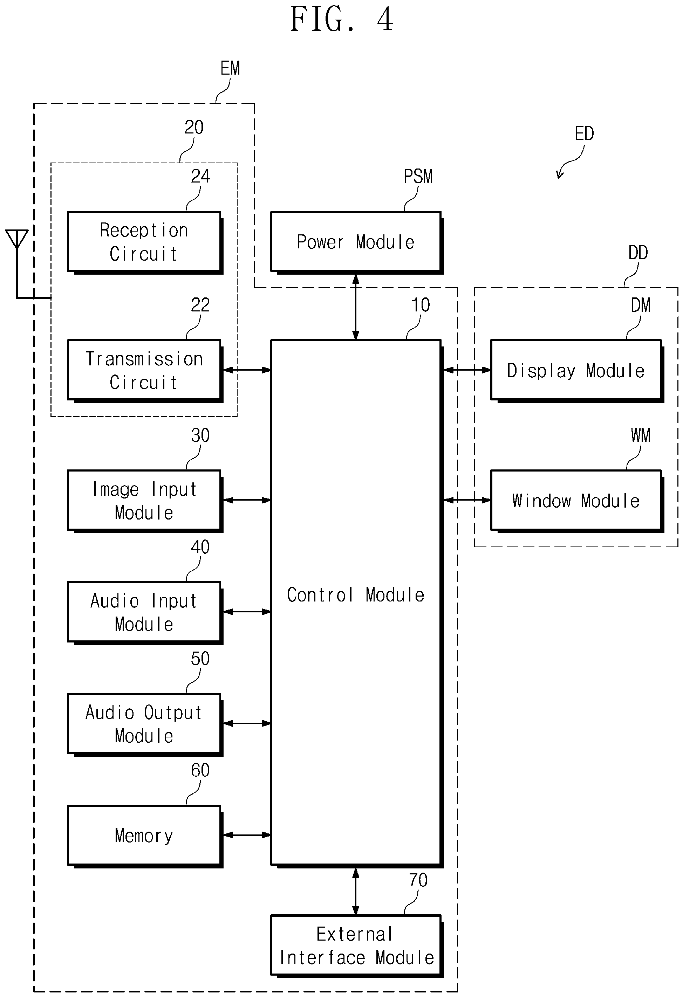

FIG. 4 is a block diagram of the electronic device ED shown in FIG. 3.

Referring to FIG. 4, the electronic device ED may include the electronic module EM, the power module PSM, and the display device DD. The electronic module EM may include a control module 10, a wireless communication module 20, an image input module 30, an audio input module 40, an audio output module 50, a memory 60, and an external interface module 70. The modules may be mounted on a circuit board to be electrically connected to each other or may be electrically connected to each other through a flexible circuit board. The electronic module EM may be electrically connected to the power module PSM.

The control module 10 may control an overall operation of the electronic device ED. For example, the control module 10 may activate or deactivate the display device DD in response to a user's input. The control module 10 may control other modules, such as the image input module 30, the audio input module 40, the audio output module 50, or the like, in response to the user's input. The control module 10 may include at least one microprocessor.

The wireless communication module 20 may transmit/receive a wireless signal to/from other terminals using a Bluetooth or WiFi link. The wireless communication module 20 may transmit/receive a voice signal using a general communication line. The wireless communication module 20 may include a transmission circuit 22 that modulates a signal to be transmitted and transmits the modulated signal and a reception circuit 24 that demodulates the signal applied thereto.

The image input module 30 may process an image signal and may convert the image signal into image data that may be displayed through the display device DD. The audio input module 40 may receive an external sound signal through a microphone in a record mode or a voice recognition mode and may convert the external sound signal to electrical voice data. The audio output module 50 may convert sound data provided thereto from the wireless communication module 20 or sound data stored in the memory 60 and may output the converted sound data to the outside.

The external interface module 70 may serve as an interface between the control module 10 and external devices, such as an external charger, a wired/wireless data port, a card (e.g., a memory card and a SIM/UIM card) socket, etc.

The power module PSM may supply a power required for the overall operation of the electronic device ED. The power module PSM may include a conventional battery device.

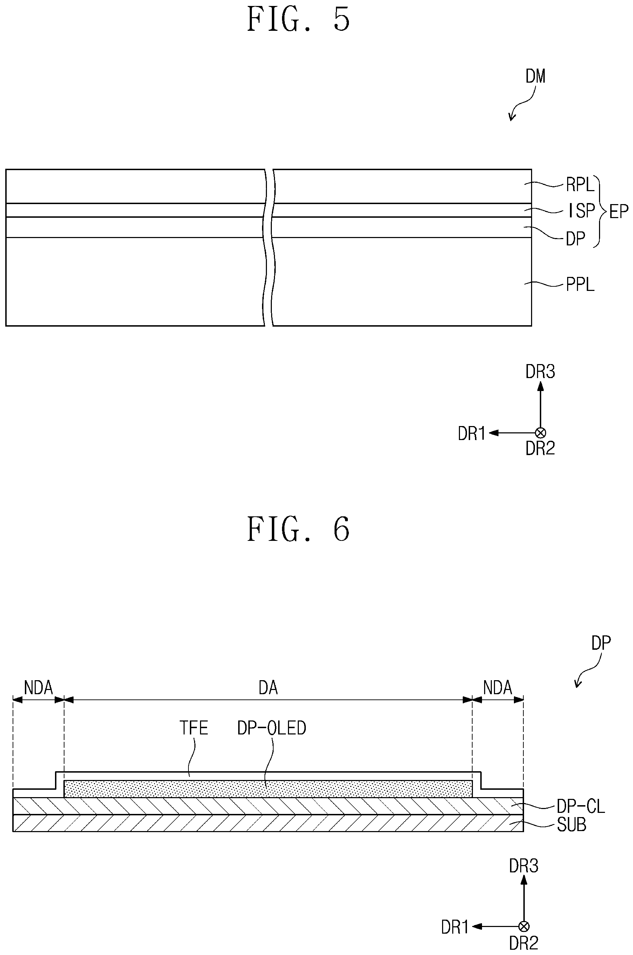

FIG. 5 is a cross-sectional view of the display module DM shown in FIG. 3.

Referring to FIG. 5, the display module DM may include the display panel DP, an input sensing part ISP located on the display panel DP, an anti-reflective layer RPL located on the input sensing part ISP, and a panel protective layer PPL located under the display panel DP. The display panel DP may be a flexible display panel. As an example, the display panel DP may include a flexible substrate and a plurality of elements located on the flexible substrate.

According to some embodiments, the display panel DP may be a light emitting type display panel, however, it should not be particularly limited. As an example, the display panel DP may be an organic light emitting display panel or an inorganic light emitting display panel. A light emitting layer of the organic light emitting display panel may include an organic light emitting material. A light emitting layer of the inorganic light emitting display panel may include a quantum dot or a quantum rod. Hereinafter, the organic light emitting display panel will be described as a representative example of the display panel DP.

The input sensing part ISP may include a plurality of sensors to sense an external input by a capacitive method. The input sensing part ISP may be directly manufactured on the display panel DP when the display module DM is manufactured.

The anti-reflective layer RPL may be located on the input sensing part ISP. The anti-reflective layer RPL may be directly formed on the input sensing part ISP when the display module DM is manufactured. The anti-reflective layer RPL may be defined as an external light reflection prevention film. The anti-reflective layer RPL may decrease a reflectance of an external light incident to the display panel DP from above the display module DM.

As an example, the input sensing part ISP may be located directly on the display panel DP, and the anti-reflective layer RPL may be directly formed on the input sensing part ISP, however, it should not be limited thereto or thereby. As an example, the input sensing part ISP may be attached to the display panel DP by an adhesive layer after being manufactured separately from the display panel DP, and the anti-reflective layer RPL may be attached to the input sensing part ISP by an adhesive layer after being manufactured separately from the input sensing part ISP.

The display panel DP, the input sensing part ISP, and the anti-reflective layer RPL may be defined as an electronic panel EP.

The panel protective layer PPL may be located under the display panel DP. The panel protective layer PPL may protect a lower portion of the display panel DP. The panel protective layer PPL may include a flexible plastic material. As an example, the panel protective layer PPL may include polyethylene terephthalate (PET).

FIG. 6 is a cross-sectional view of the display panel DP shown in FIG. 5.

FIG. 6 shows a cross-section of the display panel DP when viewed in the second direction DR2 as a representative example.

Referring to FIG. 6, the display panel DP may include a substrate SUB, a circuit element layer DP-CL located on the substrate SUB, a display element layer DP-OLED located on the circuit element layer DP-CL, and a thin film encapsulation layer TFE located on the display element layer DP-OLED.

The substrate SUB may include the display area DA and the non-display area NDA around the display area DA. The substrate SUB may include a flexible plastic material such as polyimide (PI). The display element layer DP-OLED may be located in the display area DA.

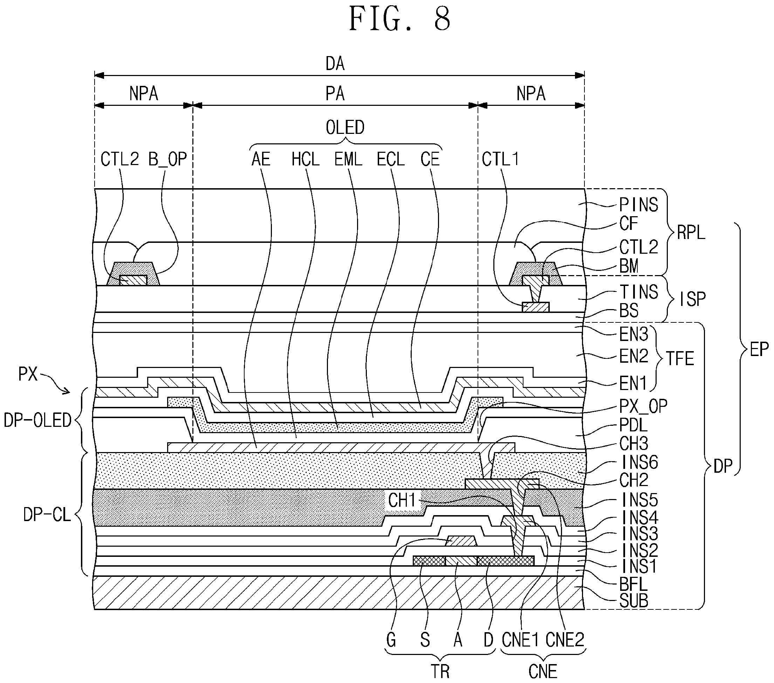

A plurality of pixels may be located in the circuit element layer DP-CL and the display element layer DP-OLED. Each pixel may include a transistor located in the circuit element layer DP-CL and a light emitting element located in the display element layer DP-OLED and connected to the transistor. The configuration of the pixel will be described in detail with reference to FIG. 8.

The thin film encapsulation layer TFE may be located on the circuit element layer DP-CL to cover the display element layer DP-OLED. The thin film encapsulation layer TFE may protect the pixels from moisture, oxygen, and a foreign substance.

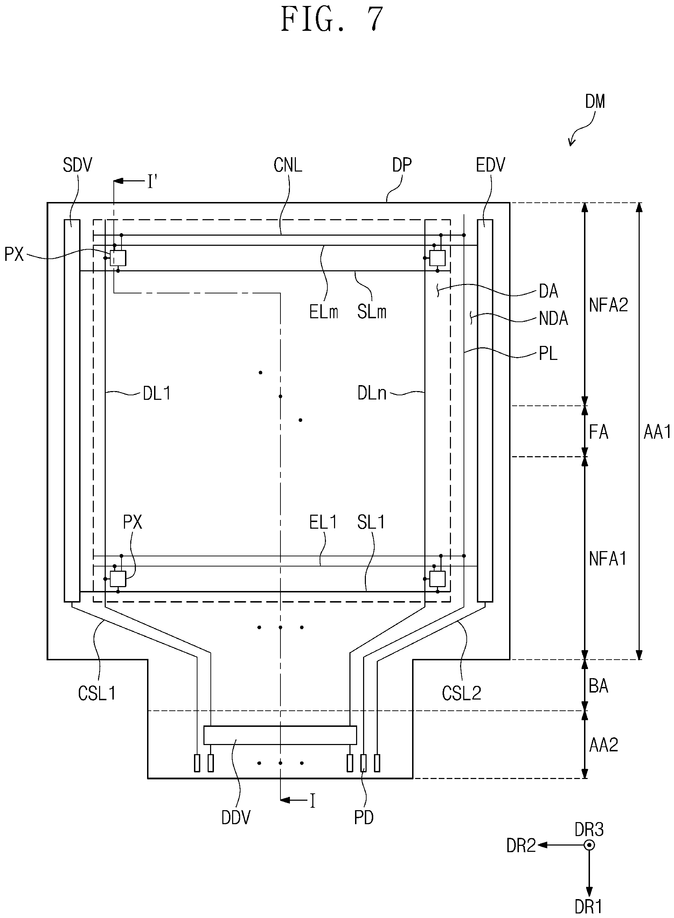

FIG. 7 is a plan view of the display panel DP shown in FIG. 3.

Referring to FIG. 7, the display module DM may include the display panel DP, a scan driver SDV, the data driver DDV, and an emission driver EDV.

The display panel DP may include a first area AA1, a second area AA2, and a bending area BA between the first area AA1 and the second area AA2. The bending area BA may extend in the second direction DR2, and the first area AA1, the bending area BA, and the second area AA2 may be arranged in the first direction DR1.

The first area AA1 may include the display area DA and the non-display area NDA around the display area DA. The non-display area NDA may surround the display area DA. The display area DA may be an area in which the image IM is displayed, and the non-display area NDA may be an area in which the image IM is not displayed. The second area AA2 and the bending area BA may be areas in which the image IM is not displayed.

When viewed in the third direction DR3, the first area AA1 may include the first non-folding area NFA1, the second non-folding area NFA2, and the folding area FA between the first non-folding area NFA1 and the second non-folding area NFA2.

The display panel DP may include a plurality of pixels PX, a plurality of scan lines SL1 to SLm, a plurality of data lines DL1 to DLn, a plurality of emission lines EL1 to ELm, first and second control lines CSL1 and CSL2, a power line PL, a plurality of connection lines CNL, and a plurality of pads PD. Each of m and n is a natural number. The pixels PX may be arranged in the display area DA and may be connected to the scan lines SL1 to SLm, the data lines DL1 to DLn, and the emission lines EL1 to ELm.

The scan driver SDV and the emission driver EDV may be located in the non-display area NDA. The scan driver SDV and the emission driver EDV may be located in the non-display area NDA to be respectively adjacent to both sides of the first area AA1, which are opposite to each other in the second direction DR2. The data driver DDV may be located in the second area AA2. The data driver DDV may be manufactured in an integrated circuit chip form and may be mounted in the second area AA2.

The scan lines SL1 to SLm may extend in the second direction DR2 and may be connected to the scan driver SDV. The data lines DL1 to DLn may extend in the first direction DR1 and may be connected to the data driver DDV via the bending area BA. The emission lines EL1 to ELm may extend in the second direction DR2 and may be connected to the emission driver EDV.

The power line PL may extend in the first direction DR1 and may be located in the non-display area NDA. The power line PL may be located between the display area DA and the emission driver EDV, however, it should not be limited thereto or thereby. That is, the power line PL may be located between the display area DA and the scan driver SDV.

The power line PL may extend to the second area AA2 via the bending area BA. When viewed in a plane (or in a plan view), the power line PL may extend to a lower end of the second area AA2. The power line PL may receive a driving voltage.

The connection lines CNL may extend in the second direction DR2 and may be arranged in the first direction DR1. The connection lines CNL may be connected to the power line PL and the pixels PX. The driving voltage may be applied to the pixels PX via the power line PL and the connection lines CNL connected to the power line PL.

The first control line CSL1 may be connected to the scan driver SDV and may extend toward the lower end of the second area AA2 via the bending area BA. The second control line CSL2 may be connected to the emission driver EDV and may extend toward the lower end of the second area AA2 via the bending area BA. The data driver DDV may be located between the first control line CSL1 and the second control line CSL2.

When viewed in the plane (or in a plan view), the pads PD may be located adjacent to the lower end of the second area AA2. The data driver DDV, the power line PL, the first control line CSL1, and the second control line CSL2 may be connected to the pads PD.

The data lines DL1 to DLn may be connected to corresponding pads PD via the data driver DDV. As an example, the data lines DL1 to DLn may be connected to the data driver DDV, and the data driver DDV may be connected to the pads PD corresponding to the data lines DL1 to DLn.

According to some embodiments, a printed circuit board may be connected to the pads PD, and a timing controller and a voltage generator may be located on the printed circuit board. The timing controller may be manufactured in an integrated circuit chip form and may be mounted on the printed circuit board. The timing controller and the voltage generator may be connected to the pads PD via the printed circuit board.

The timing controller may control an operation of the scan driver SDV, the data driver DDV, and the emission driver EDV. The timing controller may generate a scan control signal, a data control signal, and an emission control signal in response to control signals applied thereto from the outside. The voltage generator may generate the driving voltage.

The scan control signal may be applied to the scan driver SDV via the first control line CSL1. The emission control signal may be applied to the emission driver EDV via the second control line CSL2. The data control signal may be applied to the data driver DDV. The timing controller may receive image signals from the outside, may convert a data format of the image signals to a data format appropriate to an interface between the timing controller and the data driver DDV, and may provide the converted image signals to the data driver DDV.

The scan driver SDV may generate a plurality of scan signals in response to the scan control signal. The scan signals may be applied to the pixels PX via the scan lines SL1 to SLm. The scan signals may be sequentially applied to the pixels PX.

The data driver DDV may generate a plurality of data voltages corresponding to the image signals in response to the data control signal. The data voltages may be applied to the pixels PX via the data lines DL1 to DLn. The emission driver EDV may generate a plurality of emission signals in response to the emission control signal. The emission signals may be applied to the pixels PX via the emission lines EL1 to ELm.

The pixels PX may receive the data voltages in response to the scan signals. The pixels PX may emit a light having a luminance corresponding to the data voltages in response to the emission signals, and thus, the image may be displayed. An emission time of the pixels PX may be controlled by the emission signals.

FIG. 8 is a cross-sectional view of the electronic panel EP corresponding to one pixel shown in FIG. 7.

Referring to FIG. 8, the pixel PX may include a transistor TR and a light emitting element OLED. The light emitting element OLED may include a first electrode (or an anode) AE, a second electrode (or a cathode) CE, a hole control layer HCL, an electron control layer ECL, and a light emitting layer EML.

The transistor TR and the light emitting element OLED may be located on the substrate SUB. As an example, one transistor TR is shown in FIG. 8, however, the pixel PX may include a plurality of transistors and at least one capacitor to drive the light emitting element OLED.

The display area DA may include a light emitting area PA corresponding to each pixel PX and a non-light-emitting area NPA around the light emitting area PA. The light emitting element OLED may be located in the light emitting area PA.

A buffer layer BFL may be located on the substrate SUB, and the buffer layer BFL may be an inorganic layer. A semiconductor pattern may be located on the buffer layer BFL. The semiconductor pattern may include polycrystalline silicon, amorphous silicon, or metal oxide.

The semiconductor pattern may be doped with an N-type dopant or a P-type dopant. The semiconductor pattern may include a high-doped region and a low-doped region. The high-doped region may have a conductivity greater than that of the low-doped region and may serve as a source electrode and a drain electrode of the transistor TR. The low-doped region may correspond to an active (or a channel) region of the transistor TR.

A source S, an active region A, and a drain D of the transistor TR may be formed from the semiconductor pattern. A first insulating layer INS1 may be located on the semiconductor pattern. A gate G of the transistor TR may be located on the first insulating layer INS1. A second insulating layer INS2 may be located on the gate G. A third insulating layer INS3 may be located on the second insulating layer INS2.

A connection electrode CNE may include a first connection electrode CNE1 and a second connection electrode CNE2 to connect the transistor TR to the light emitting element OLED. The first connection electrode CNE1 may be located on the third insulating layer INS3 and may be connected to the drain D via a first contact hole CH1 defined through the first, second, and third insulating layers INS1, INS2, and INS3.

A fourth insulating layer INS4 may be located on the first connection electrode CNE1. A fifth insulating layer INS5 may be located on the fourth insulating layer INS4. The second connection electrode CNE2 may be located on the fifth insulating layer INS5. The second connection electrode CNE2 may be connected to the first connection electrode CNE1 via a second contact hole CH2 defined through the fourth insulating layer INS4 and the fifth insulating layer INS5.

A sixth insulating layer INS6 may be located on the second connection electrode CNE2. The layers from the buffer layer BFL to the sixth insulating layer INS6 may be defined as the circuit element layer DP-CL. Each of the first to sixth insulating layers INS1 to INS6 may be an inorganic layer or an organic layer.

The first electrode AE may be located on the sixth insulating layer INS6. The first electrode AE may be connected to the second connection electrode CNE2 via a third contact hole CH3 defined through the sixth insulating layer INS6. A pixel definition layer PDL may be located on the first electrode AE and the sixth insulating layer INS6. The pixel definition layer PDL may be provided with an opening PX_OP defined therethrough to expose a portion of the first electrode AE.

The hole control layer HCL may be located on the first electrode AE and the pixel definition layer PDL. The hole control layer HCL may include a hole transport layer and a hole injection layer.

The light emitting layer EML may be located on the hole control layer HCL. The light emitting layer EML may be located in an area corresponding to the opening PX_OP. The light emitting layer EML may include an organic material and/or an inorganic material. The light emitting layer EML may generate a light having one of red, green, and blue colors.

The electron control layer ECL may be located on the light emitting layer EML and the hole control layer HCL. The electron control layer ECL may include an electron transport layer and an electron injection layer. The hole control layer HCL and the electron control layer ECL may be commonly located in the light emitting area PA and the non-light-emitting area NPA.

The second electrode CE may be located on the electron control layer ECL. The second electrode CE may be commonly located over the pixels PX. Layers in which the light emitting element OLED is located may be referred to as the display element layer DP-OLED.

The thin film encapsulation layer TFE may be located on the second electrode CE to cover the pixel PX. The thin film encapsulation layer TFE may include a first encapsulation layer EN1 located on the second electrode CE, a second encapsulation layer EN2 located on the first encapsulation layer EN1, and a third encapsulation layer EN3 located on the second encapsulation layer EN2.

The first and third encapsulation layers EN1 and EN3 may include an inorganic insulating layer and may protect the pixel PX from moisture and oxygen. The second encapsulation layer EN2 may include an organic insulating layer and may protect the pixel PX from a foreign substance such as dust particles.

A first voltage may be applied to the first electrode AE via the transistor TR, and a second voltage having a voltage level lower than that of the first voltage may be applied to the second electrode CE. Holes and electrons injected into the light emitting layer EML may be recombined to generate excitons, and the light emitting element OLED may emit the light by the excitons that return to a ground state from an excited state.

The input sensing part ISP may be located on the thin film encapsulation layer TFE. The input sensing part ISP may be directly manufactured on an upper surface of the thin film encapsulation layer TFE.

A base layer BS may be located on the thin film encapsulation layer TFE. The base layer BS may include an inorganic insulating layer. At least one inorganic insulating layer may be provided on the thin film encapsulation layer TFE as the base layer BS.

The input sensing part ISP may include a first conductive pattern CTL1 and a second conductive pattern CTL2 located on the first conductive pattern CTL1. The first conductive pattern CTL1 may be located on the base layer BS. An insulating layer TINS may be located on the base layer BS to cover the first conductive pattern CTL1. The insulating layer TINS may include an inorganic insulating layer or an organic insulating layer. The second conductive pattern CTL2 may be located on the insulating layer TINS.

The first and second conductive patterns CTL1 and CTL2 may overlap the non-light-emitting area NPA. According to some embodiments, the first and second conductive patterns CTL1 and CTL2 may be located in the non-light-emitting area NPA between the light emitting areas PA and may have a mesh shape.

The first and second conductive patterns CTL1 and CTL2 may form the sensors of the input sensing part ISP. As an example, the first and second conductive patterns CTL1 and CTL2 having the mesh shape may be separated from each other in a predetermined area to form the sensors. A portion of the second conductive pattern CTL2 may be connected to the first conductive pattern CTL1.

The anti-reflective layer RPL may be located on the second conductive pattern CTL2. The anti-reflective layer RPL may include a black matrix BM and a plurality of color filters CF. The black matrix BM may overlap the non-light-emitting area NPA, and the color filters CF may overlap the light emitting areas PA, respectively.

The black matrix BM may be located on the insulating layer TINS to cover the second conductive pattern CTL2. The black matrix BM may be provided with an opening B_OP defined therethrough to overlap the light emitting area PA and the opening PX_OP. The black matrix BM may absorb and block the light. A width of the opening B_OP may be greater than a width of the opening PX_OP.

The color filters CF may be located on the insulating layer TINS and the black matrix BM. The color filters CF may be located in the openings B_OP, respectively. A planarization insulating layer PINS may be located on the color filters CF. The planarization insulating layer PINS may provide a flat upper surface.

In a case where the external light incident on the display panel DP is provided to the user after being reflected by the display panel DP, like a mirror, the user may perceive the external light. To prevent or mitigate this from happening, the anti-reflective layer RPL may include the color filters CF that display the same colors as those of lights emitted from the corresponding pixels PX. The color filters CF may filter the external light to have the same color as those of the lights emitted from the corresponding pixels PX. In this case, the external light may not be perceived by the user.

However, the present disclosure should not be limited thereto or thereby, and the anti-reflective layer RPL may include a polarizing film to relatively reduce the reflectance of the external light. The polarizing film may be attached to the input sensing part ISP by an adhesive layer after being manufactured separately. The polarizing film may include a retarder and/or a polarizer.

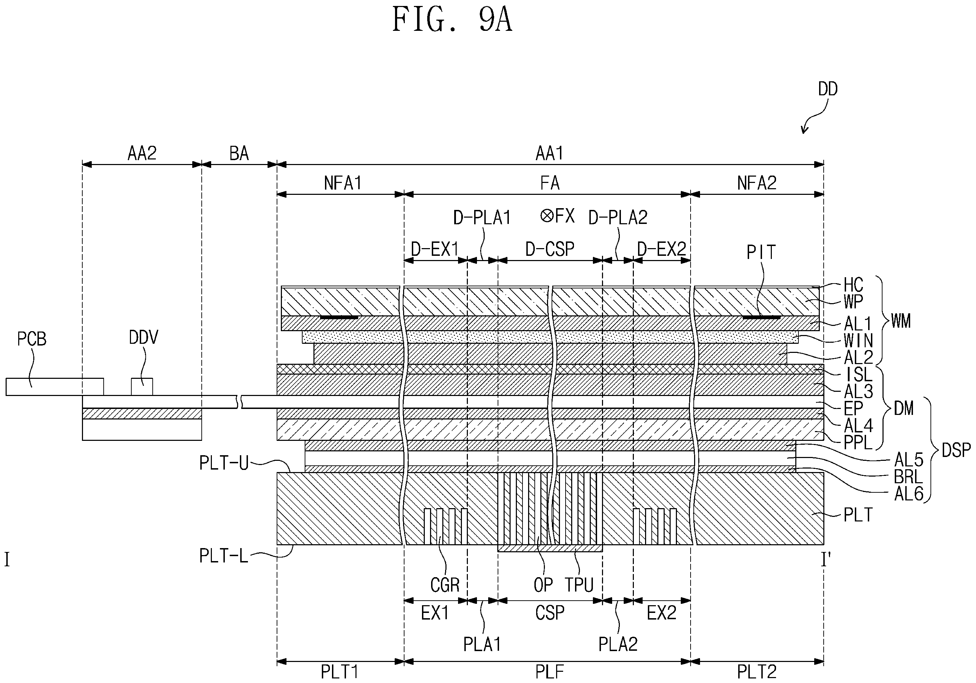

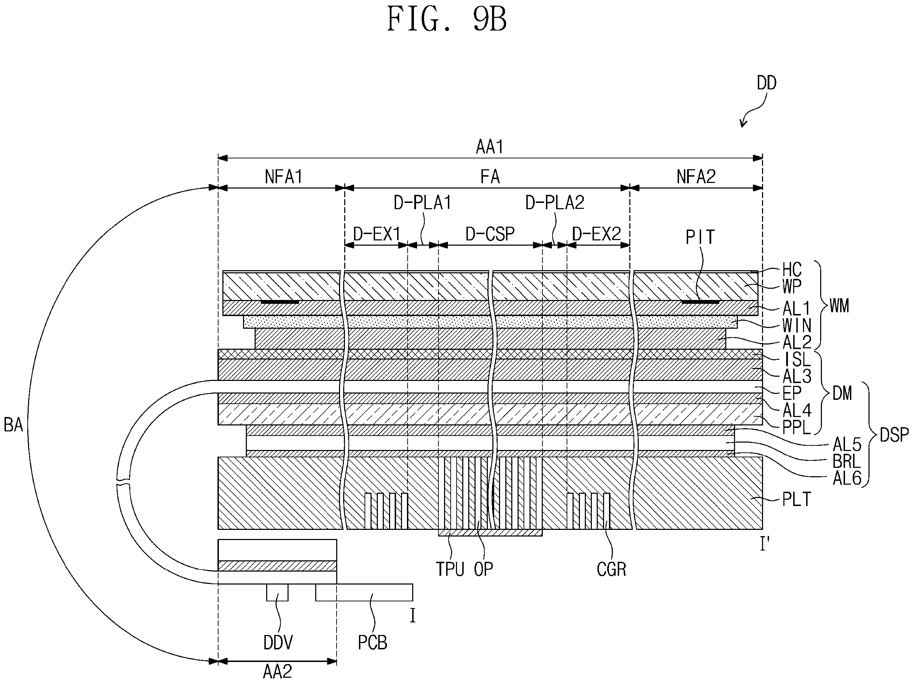

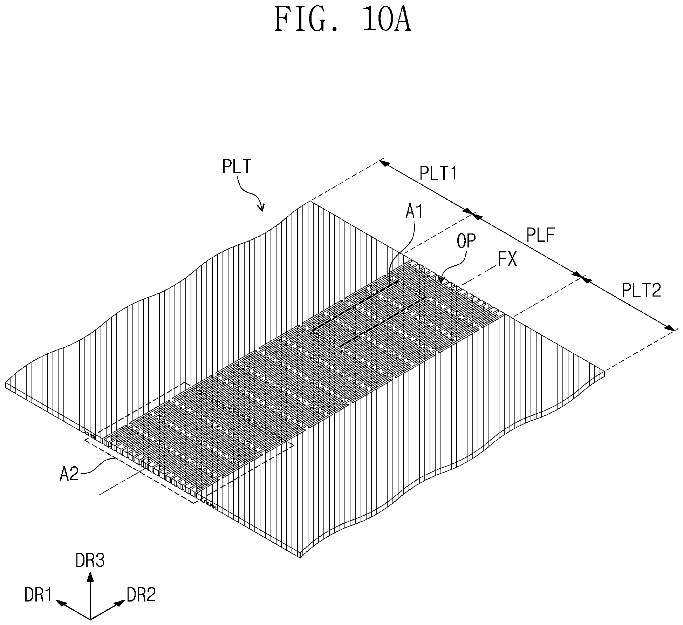

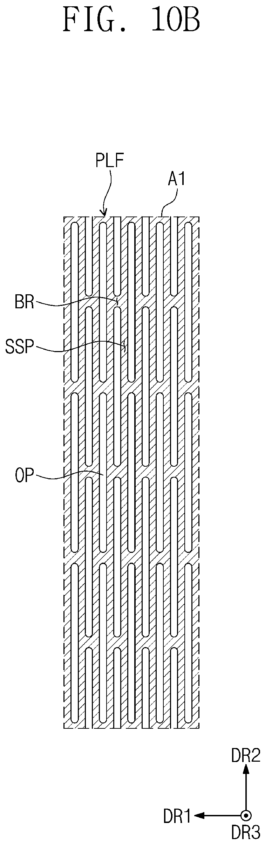

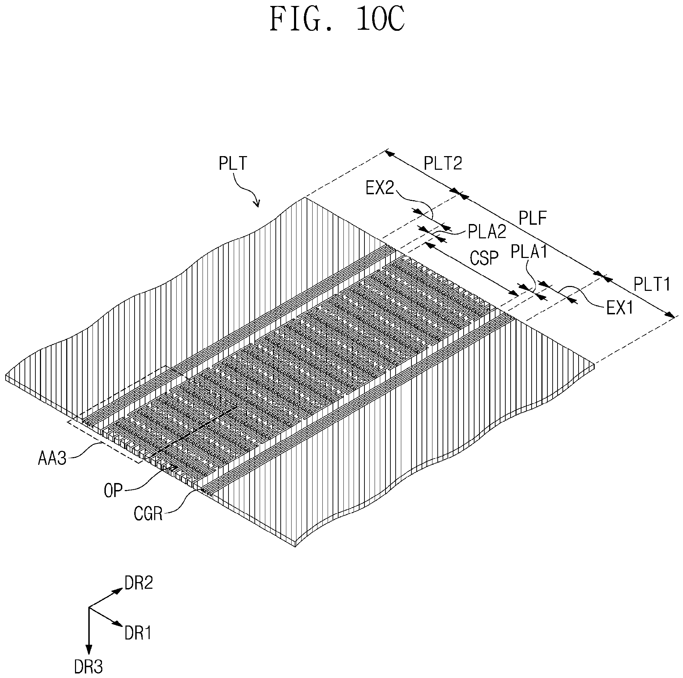

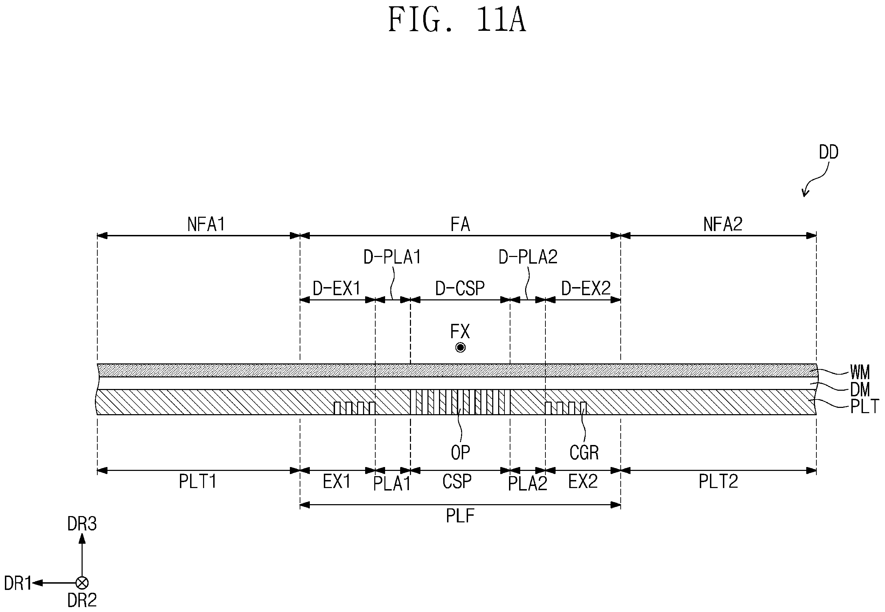

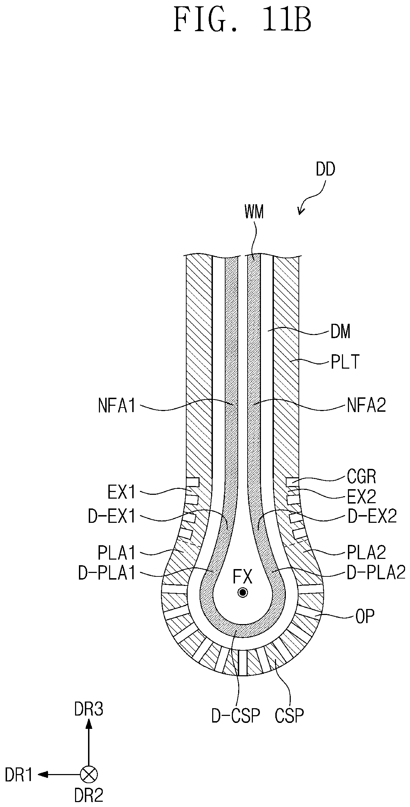

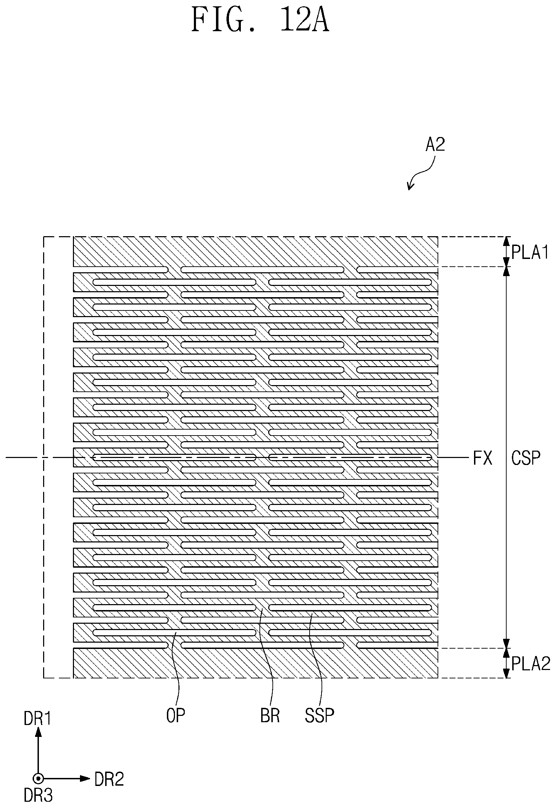

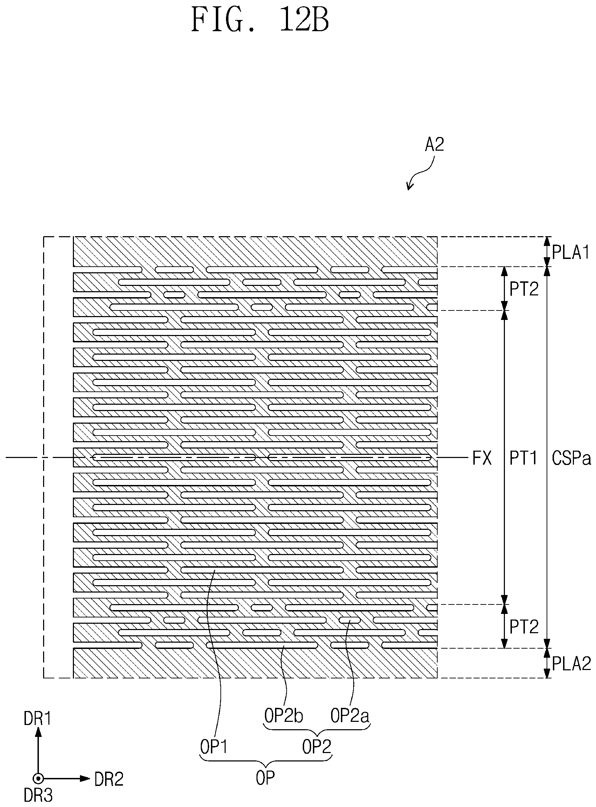

FIG. 9A is a cross-sectional view taken along a line I-I' of FIG. 7. FIG. 9B is a view showing a bent state of the bending area BA of FIG. 9A. FIG. 10A is a perspective view of a support plate PLT shown in FIG. 9A. FIG. 10B is an enlarged view of a first area A1 shown in FIG. 10A. FIG. 10C is a perspective view of the support plate PLT shown in FIG. 10A turned upside down. FIGS. 11A and 11B are views illustrating a folding operation of the window module WM, the display module DM, and the support plate PLT of FIG. 9A according to some embodiments of the present disclosure. FIG. 12A is a plan view of a second area A2 shown in FIG. 10A. FIG. 12B is a view illustrating a curved portion CSPa according to some embodiments of the present disclosure.

FIG. 9A shows a portion of a display part DSP, a portion of the support plate PLT, and a portion of the window module WM as a representative example.

FIGS. 11A and 11B are cross-sectional views.

For the convenience of explanation, in FIGS. 11A and 11B, each of the window module WM and the display module DM is schematically shown as a single layer, and a fifth adhesive layer AL5, a barrier layer BRL, and a sixth adhesive layer AL6 of FIG. 9A are omitted.

Because a folding axis FX of FIGS. 11A and 11B is the same or substantially the same as the folding axis FX of FIG. 2A, details thereof will be omitted.

Referring to FIG. 9A, the folding area FA may include a curved area D-CSP, a first reverse curvature area D-EX1, a second reverse curvature area D-EX2, a first flat area D-PLA1, and a second flat area D-PLA2. The curved area D-CSP may overlap the folding axis FX. The first reverse curvature area D-EX1 may be located between the curved area D-CSP and the first non-folding area NFA1. The second reverse curvature area D-EX2 may be located between the curved area D-CSP and the second non-folding area NFA2. The first flat area D-PLA1 may be located between the first reverse curvature area D-EX1 and the curved area D-CSP. The second flat area D-PLA2 may be located between the second reverse curvature area D-EX2 and the curved area D-CSP. The curved area D-CSP, the first reverse curvature area D-EX1, the second reverse curvature area D-EX2, the first flat area D-PLA1, and the second flat area D-PLA2 will be described in detail with reference to FIGS. 11A and 11B.

The display device DD may include the display part DSP, the window module WM located on the display part DSP, the support plate PLT located under the display part DSP, and a cover layer TPU. The support plate PLT may support the display module DM. The window module WM may include a window WIN, a window protective layer WP, a hard coating layer HC, and first and second adhesive layers AL1 and AL2.

The display part DSP may include the electronic panel EP, an impact-absorbing layer ISL, the panel protective layer PPL, the barrier layer BRL, and third, fourth, fifth, and sixth adhesive layers AL3, AL4, AL5, and AL6. The impact-absorbing layer ISL, the electronic panel EP, the panel protective layer PPL, the third adhesive layer AL3, and the fourth adhesive layer AL4 may be defined as the display module DM. Because configurations of the electronic panel EP and the panel protective layer PPL are previously described with reference to FIG. 5, descriptions of the same elements will not be repeated.

The impact-absorbing layer ISL may be located on the electronic panel EP. The impact-absorbing layer ISL may absorb external impacts applied to the electronic panel EP from above the display device DD and may protect the electronic panel EP. The impact-absorbing layer ISL may be manufactured in the form of a stretched film.

The impact-absorbing layer ISL may include a flexible plastic material. The flexible plastic material may be a synthetic resin film. As an example, the impact-absorbing layer ISL may include the flexible plastic material, such as polyimide (PI) or polyethylene terephthalate (PET).

The window WIN may be located on the impact-absorbing layer ISL. The window WIN may protect the electronic panel EP from external scratches. The window WIN may have an optically transparent property. The window WIN may include a glass material, however, it should not be limited thereto or thereby. According to some embodiments, the window WIN may include a synthetic resin film.

The window WIN may have a single-layer or multi-layer structure. As an example, the window WIN may include a plurality of synthetic resin films attached to each other by an adhesive or a glass substrate and a synthetic resin film attached to the glass substrate by an adhesive.

The window protective layer WP may be located on the window WIN. The window protective layer WP may include a flexible plastic material, such as polyimide (PI) or polyethylene terephthalate (PET). The hard coating layer HC may be located on the window protective layer WP.

A print layer PIT may be located on a lower surface of the window protective layer WP. The print layer PIT may have a black color, however, a color of the print layer PIT should not be limited to the black color. The print layer PIT may be located adjacent to an edge of the window protective layer WP.

The barrier layer BRL may be located under the panel protective layer PPL. The barrier layer BRL may be configured to increase a resistance to a compressive force caused by an external pressure. Accordingly, the barrier layer BRL may be configured to prevent the electronic panel EP from being deformed. The barrier layer BRL may include a flexible plastic material, such as polyimide or polyethylene terephthalate.

The barrier layer BRL may have a color that absorbs the light. As an example, the barrier layer BRL may have a black color. In this case, when looking at the display module DM from above the display module DM, components located under the barrier layer BRL may not be viewed by the user.

The first adhesive layer AL1 may be located between the window protective layer WP and the window WIN. The window protective layer WP may be attached to the window WIN by the first adhesive layer AL1. The first adhesive layer AL1 may cover the print layer PIT.

The second adhesive layer AL2 may be located between the window WIN and the impact-absorbing layer ISL. The window WIN may be attached to the impact-absorbing layer ISL by the second adhesive layer AL2.

The third adhesive layer AL3 may be located between the impact-absorbing layer ISL and the electronic panel EP. The impact-absorbing layer ISL may be attached to the electronic panel EP by the third adhesive layer AL3.

The fourth adhesive layer AL4 may be located between the electronic panel EP and the panel protective layer PPL. The electronic panel EP may be attached to the panel protective layer PPL by the fourth adhesive layer AL4.

The fifth adhesive layer AL5 may be located between the panel protective layer PPL and the barrier layer BRL. The panel protective layer PPL may be attached to the barrier layer BRL by the fifth adhesive layer AL5.

The sixth adhesive layer AL6 may be located between the barrier layer BRL and the support plate PLT. The support plate PLT may be located under the barrier layer BRL, and the sixth adhesive layer AL6 may be located between the barrier layer BRL and the support plate PLT. The sixth adhesive layer AL6 may overlap the first and second non-folding areas NFA1 and NFA2 and the folding area FA. The barrier layer BRL may be attached to the support plate PLT by the sixth adhesive layer AL6. Hereinafter, the sixth adhesive layer AL6 may be referred to as an upper adhesive layer AL6.

The first to sixth adhesive layers AL1 to AL6 may include a pressure sensitive adhesive (PSA) or a transparent adhesive such as an optically clear adhesive (OCA), however, types of the adhesive should not be particularly limited.

The panel protective layer PPL may have a thickness smaller than a thickness of the window protective layer WP, and the barrier layer BRL may have a thickness smaller than the thickness of the panel protective layer PPL. The electronic panel EP may have a thickness smaller than the thickness of the barrier layer BRL and equal or substantially equal to a thickness of the window WIN. The impact-absorbing layer ISL may have a thickness smaller than the thickness of the electronic panel EP.

The first adhesive layer AL1 may have a thickness equal to or substantially equal to the thickness of the barrier layer BRL, and each of the second adhesive layer AL2 and the third adhesive layer AL3 may have a thickness equal to or substantially equal to the thickness of the panel protective layer PPL. The fourth adhesive layer AL4 may have a thickness equal or substantially equal to a thickness of the fifth adhesive layer AL5.

The thickness of each of the fourth adhesive layer AL4 and the fifth adhesive layer AL5 may be smaller than the thickness of the electronic panel EP and may be greater than the thickness of the impact-absorbing layer ISL. The sixth adhesive layer AL6 may have a thickness smaller than the thickness of the impact-absorbing layer ISL. The hard coating layer HC may have a thickness smaller than the thickness of the sixth adhesive layer AL6.

The electronic panel EP, the impact-absorbing layer ISL, the panel protective layer PPL, and the third and fourth adhesive layers AL3 and AL4 may have the same width, or substantially the same width as each other. The window protective layer WP and the first adhesive layer AL1 may have the same width, or substantially the same width as each other. The barrier layer BRL and the fifth and sixth adhesive layers AL5 and AL6 may have the same width, or substantially the same width as each other.

The widths of the electronic panel EP, the impact-absorbing layer ISL, the panel protective layer PPL, and the third and fourth adhesive layers AL3 and AL4 may be greater than the widths of the window protective layer WP and the first adhesive layer AL1. Edges of the electronic panel EP, the impact-absorbing layer ISL, the panel protective layer PPL, and the third and fourth adhesive layers AL3 and AL4 may be located at an outside of edges of the window protective layer WP and the first adhesive layer AL1.

Widths of the window WIN and the second adhesive layer AL2 may be smaller than the widths of the window protective layer WP and the first adhesive layer AL1. The width of the second adhesive layer AL2 may be smaller than the width of the window WIN. One or more edges of the window WIN may be located inside the edges of the window protective layer WP and the first adhesive layer AL1. One or more edges of the second adhesive layer AL2 may be located inside the edges of the window WIN.

The widths of the barrier layer BRL and the fifth and sixth adhesive layers AL5 and AL6 may be smaller than the widths of the window protective layer WP and the first adhesive layer AL1. Edges of the barrier layer BRL and the fifth and sixth adhesive layers AL5 and AL6 may be located inside the edges of the window protective layer WP and the first adhesive layer AL1.

The support plate PLT may be located under the display part DSP and may support the display part DSP. The support plate PLT may be located under the electronic panel EP and may support the electronic panel EP. A width of the support plate PLT may be the same or substantially the same as the width ofthe first region AA1. The support plate PLT may have a rigidity higher than that of the display part DSP.

The support plate PLT may include a non-metallic material. As an example, the support plate PLT may include a fiber reinforced composite. The fiber reinforced composite may include a carbon fiber reinforced plastic (CFRP) or a glass fiber reinforced plastic (GFRP).

Because the support plate PLT includes the non-metallic material, such as the fiber reinforced composite, the support plate PLT may be lightweight. As the support plate PLT includes the non-metallic material, such as the fiber reinforced composite, the support plate PLT may have a light weight compared with a metal support plate formed of a metal material and may have a modulus and strength similar to those of the metal support plate. It will be understood that other ways of making the support plate PLT lightweight are possible and the specific examples here are purely illustrative.

In addition, because the support plate PLT includes the non-metallic material, such as the fiber reinforced composite, a shape machining process for the support plate PLT may be easier compared with the metal support plate. As an example, the support plate PLT including the non-metallic material, such as a fiber reinforced composite, may be easily processed by using a laser process or a micro-blast process. However, the present disclosure should not be limited thereto or thereby, and according to some embodiments, the support plate PLT may include a metal material.

The support plate PLT may include a first non-folding portion PLT1, a folding portion PLF, and a second non-folding portion PLT2. The first non-folding portion PLT1 may overlap the first non-folding area NFA1. The folding portion PLF may overlap the folding area FA. The second non-folding portion PLT2 may overlap the second non-folding area NFA2.

The folding portion PLF may include a curved portion CSP, a first reverse curvature portion EX1, a second reverse curvature portion EX2, a first flat portion PLA1, and a second flat portion PLA2. The curved portion CSP may overlap the curved area D-CSP.

A plurality of openings OP may be defined through the curved portion CSP. The openings OP may be formed through portions of the curved portion CSP in the third direction DR3. When viewed in the second direction DR2, the openings OP may be arranged spaced apart from each other in the first direction DR1. The openings OP may be formed by the laser process or the micro-blast process, or in any suitable manner.

As the openings OP are defined through the curved portion CSP overlapping the curved area D-CSP, a flexibility of the curved portion CSP may increase. As a result, the support plate PLT may be folded with respect to the folding area FA.

The first reverse curvature portion EX1 may overlap the first reverse curvature area D-EX1. The first reverse curvature portion EX1 may be located between the curved portion CSP and the first non-folding portion PLT1. The second reverse curvature portion EX2 may overlap the second reverse curvature area D-EX2. The second reverse curvature portion EX2 may be located between the curved portion CSP and the second non-folding portion PLT2.

Reverse curvature grooves CGR may be defined in a lower surface of the first reverse curvature portion EX1 and a lower surface of the second reverse curvature portion EX2. The reverse curvature grooves CGR may be arranged spaced apart from each other in the first direction DR1. The reverse curvature grooves CGR may extend from a lower surface PLT-L of the support plate PLT toward an upper surface PLT-U of the support plate PLT. As an example, the reverse curvature grooves CGR may extend to a position corresponding to a half of the thickness of the support plate PLT. The first and second reverse curvature portions EX1 and EX2 will be described in detail with reference to FIGS. 10C and 11A.

The first flat portion PLA1 may overlap the first flat area D-PLA1. The first flat portion PLA1 may be located between the first reverse curvature portion EX1 and the curved portion CSP. The second flat portion PLA2 may overlap the second flat area D-PLA2. The second flat portion PLA2 may be located between the second reverse curvature portion EX2 and the curved portion CSP. The first flat portion PLA1 and the second flat portion PLA2 will be described in detail with reference to FIGS. 10C and 11A.

The cover layer TPU may be located on the lower surface PLT-L of the support plate PLT. The cover layer TPU may be located on a lower surface of the curved portion CSP. The cover layer TPU may overlap the openings OP.

The cover layer TPU may be located under the curved portion CSP to cover the openings OP. A width of an area where the openings OP are formed may be the same or substantially the same as the width of the cover layer TPU. The cover layer TPU may prevent moisture and foreign substances from entering the openings OP.

According to some embodiments, an adhesive layer may be located between the cover layer TPU and the support plate PLT. The cover layer TPU may be attached to the support plate PLT by the adhesive layer.

According to some embodiments, the display device DD may further include a digitizer, a shielding layer, and a heat dissipation layer, which are located under the support plate PLT.

Referring to FIG. 9B, the panel protective layer PPL and the fourth adhesive layer AL4 may not be located in the bending area BA. The panel protective layer PPL and the fourth adhesive layer AL4 may be located under the electronic panel EP to partially overlap the second area AA2. The data driver DDV may be located in the second area AA2 and may be located under the electronic panel EP.

The printed circuit board PCB may be connected to the electronic panel EP in the second area AA2. The printed circuit board PCB may be connected to one side of the electronic panel EP in the second area AA2. The bending area BA may be bent, and the second area AA2 may be located under the first area AA1. Accordingly, the data driver DDV and the printed circuit board PCB may be located under the first area AA1.

Referring to FIG. 10A, when viewed in the plane (or in a plan view), the support plate PLT may have a rectangular shape defined by short sides extending in the first direction DR1 and long sides extending in the second direction DR2, however, this is merely an example. According to embodiments, the support plate PLT may have a variety of shapes.

The support plate PLT may include the first non-folding portion PLT1, the folding portion PLF, and the second non-folding portion PLT2. The folding portion PLF may be located between the first non-folding portion PLT1 and the second non-folding portion PLT2. The first non-folding portion PLT1, the folding portion PLF, and the second non-folding portion PLT2 may be arranged in a direction parallel to the first direction DR1. The first non-folding portion PLT1 and the second non-folding portion PLT2 may respectively overlap the first non-folding area NFA1 and the second non-folding area NFA2 shown in FIGS. 7 and 9A. The folding portion PLF may overlap the folding area FA shown in FIGS. 7 and 9A.

As an example, each of the first non-folding portion PLT1 and the second non-folding portion PLT2 may have a quadrangular shape parallel to a plane defined by the first direction DR1 and the second direction DR2, however, it should not be limited thereto or thereby. According to one or more embodiments, each of the first and second non-folding portions PLT1 and PLT2 may have a variety of shapes.

Referring to FIGS. 10B and 12A, a grid pattern may be defined in the folding portion PLF. As an example, the openings OP may be defined through the folding portion PLF. The openings OP may be arranged in accordance with a predetermined rule. The openings OP may be arranged in a grid shape, and thus, the grid pattern may be formed in the folding portion PLF. The grid shape or pattern is an example of a predetermined rule for the openings OP.

The openings OP may be arranged in the first direction DR1 and the second direction DR2. When viewed in the plane (or in a plan view), the openings OP adjacent to each other in the first direction DR1 may be arranged staggered with each other.

The openings OP may extend longer in the second direction DR2 than in the first direction DR1. That is, the openings OP may extend in a direction parallel or substantially parallel to the folding axis FX.

The folding portion PLF may include a plurality of branches BR and a plurality of supporters SSP. The supporters SSP may be located between the openings OP adjacent to each other in the first direction DR1. The branches BR may be located between the openings OP adjacent to each other in the second direction DR2. The supporters SSP may extend in the second direction DR2, and the branches BR may extend in the first direction DR1. The branches BR may connect the supporters SSP adjacent to each other in the first direction DR1. The openings OP may be defined by the supporters SSP and the branches BR.

Referring to FIG. 10C, the folding portion PLF may include the curved portion CSP, the first reverse curvature portion EX1, the second reverse curvature portion EX2, the first flat portion PLA1, and the second flat portion PLA2. The curved portion CSP may correspond to an area through which the openings OP are defined.

The first reverse curvature portion EX1 may be located between the first non-folding portion PLT1 and the curved portion CSP. The second reverse curvature portion EX2 may be located between the second non-folding portion PLT2 and the curved portion CSP.

The reverse curvature grooves CGR may be defined in the lower surface of the first reverse curvature portion EX1 and the lower surface of the second reverse curvature portion EX2. The reverse curvature grooves CGR may be arranged in the first direction DR1 and may extend in the second direction DR2. As the reverse curvature grooves CGR are defined, the first reverse curvature portion EX1 and the second reverse curvature portion EX2 may be easily bent when folding portion PLF is folded. The reverse curvature grooves CGR will be described in detail with reference to FIGS. 11A and 11B.

The first flat portion PLA1 may be located between the first reverse curvature portion EX1 and the curved portion CSP. When viewed in the plane (or in a plan view), the first flat portion PLA1 may have a quadrangular shape parallel to a plane defined by short sides extending in the first direction DR1 and long sides extending in the second direction DR2, however, it should not be limited thereto or thereby.

The second flat portion PLA2 may be located between the second reverse curvature portion EX2 and the curved portion CSP. When viewed in the plane (or in a plan view), the second flat portion PLA2 may have a quadrangular shape parallel to a plane defined by short sides extending in the first direction DR1 and long sides extending in the second direction DR2, however, it should not be limited thereto or thereby.

Referring to FIGS. 10A, 10C, 11A, and 11B, when the folding area FA is folded with respect to the folding axis FX, the support plate PLT, the display module DM, and the window module WM may be folded. The folding area FA may be bent, and thus, the support plate PLT, the display module DM, and the window module WM may be folded. The first non-folding area NFA1 and the second non-folding area NFA2 may rotate with respect to the folding axis FX and may face each other. The folding area FA may be bent in a curved shape when being folded. When the folding area FA is bent in the curved shape, the display module DM, the support plate PLT, and the window module WM may be partially bent in the curved shape.

When the folding area FA is bent in the curved shape, a portion of the folding area FA overlapping the folding axis FX may have a predetermined curvature. The curved area D-CSP may be bent to have a predetermined curvature when the display device DD is folded. The curved portion CSP may be bent to have a predetermined curvature when the display device DD is folded. As the openings OP are defined through the curved portion CSP, the curved portion CSP may be easily bent.

The first reverse curvature area D-EX1 and the second reverse curvature area D-EX2 may be bent. The first reverse curvature area D-EX1 may be bent from the first non-folding area NFA1 and may extend to the first flat area D-PLA1 and the curved area D-CSP. The second reverse curvature area D-EX2 may be bent from the second non-folding area NFA2 and may extend to the second flat area D-PLA2 and the curved area D-CSP. The first reverse curvature area D-EX1 and the second reverse curvature area D-EX2 may be bent in a direction opposite to a direction in which the curved area D-CSP is bent.

As the first reverse curvature area D-EX1 and the second reverse curvature area D-EX2 are bent in the direction opposite to the bent direction of the curved area D-CSP, the first reverse curvature portion EX1 and the second reverse curvature portion EX2, which respectively overlap the first reverse curvature area D-EX1 and the second reverse curvature area D-EX2, may be bent in the direction opposite to the bent direction of the curved portion CSP. As the reverse curvature grooves CGR are defined in the lower surface of the first reverse curvature portion EX1 and the lower surface of the second reverse curvature portion EX2, the first reverse curvature portion EX1 and the second reverse curvature portion EX2, which respectively overlap the first reverse curvature area D-EX1 and the second reverse curvature area D-EX2, may be easily bent.

Referring to FIGS. 10A and 12B, the curved portion CSPa may include a first portion PT1 and second portions PT2. The first portion PT1 may overlap a folding axis FX. The second portions PT2 may be located at both sides of the first portion PT1, which are opposite to each other in the first direction DR1. The second portions PT2 may be located between the first portion PT1 and a first flat portion PLA1 and between the first portion PT1 and a second flat portion PLA2. Hereinafter, for the convenience of explanation, one second portion PT2 of two second portions PT2 will be described, and the other second portion PT2 of the two second portions PT2 may have the same or substantially the same structure as the one second portion PT2.

A plurality of openings OP may be defined through the first portion PT1 and the second portion PT2. The openings OP defined through the first portion PT1 may be referred to as first openings OP1. The openings OP defined through the second portion PT2 may be referred to as second openings OP2. The first openings OP1 may be the same or substantially the same as the openings OP shown in FIG. 10B, and thus, details thereof will be omitted.

The second openings OP2 defined through the second portion PT2 may be arranged in a different pattern from the first openings OP1 defined through the first portion PT1. In detail, the second openings OP2 may include first type openings OP2a and second type openings OP2b. The first type openings OP2a may have a size smaller than a size of the second type openings OP2b. The first type openings OP2a may be alternately arranged with the second type openings OP2b in the second direction DR2.

As an example, the second openings OP2 may be arranged in first to fourth columns in the second portion PT2, which are sequentially arranged in a direction going to the first flat portion PLA1 from the first portion PT1. The column may correspond to the second direction DR2, or substantially to the second direction DR2.

The first type openings OP2a defined in the first column and the second column may have the same size in the second direction DR2. The first type openings OP2a defined in the third column and the fourth column may have the same size in the second direction DR2. The size of the first type openings OP2a defined in the second column may be smaller than the size of the first type openings OP2a defined in the third column.

The second type openings OP2b defined in the first and second columns may have the same size in the second direction DR2. The second type openings OP2b defined in the third and fourth columns may have the same size in the second direction DR2. The second type openings OP2b defined in the second column may have a size greater than the size of the second type openings OP2b defined in the third column.

As the size of the first type openings OP2a and the size of the second type openings OP2b are different from each other, the number of the branches BR arranged in the second portion PT2 may be greater than the number of the branches BR arranged in the first portion PT1. That is, a size ratio of the openings OP1 and OP2 to the branches BR may be relatively smaller in the second portion PT2 than in the first portion PT1. Accordingly, a rigidity of the second portion PT2 may increase. The rigidity may be defined as the force with which an object resists an external force when the external force is applied to the object.

Referring to FIGS. 11B and 12B, when the curved portions CSP and CSPa are folded with respect to the folding axis FX, the rigidity of a portion of the curved portion CSP, which does not include the second portion PT2 of FIG. 12B, adjacent to a boundary between the curved portion CSP and the first and second flat portions PLA1 and PLA2 may decrease. Accordingly, the portion of the curved portion CSP may be sharply bent. Then, a portion of the display module DM, which is located on the curved portion CSP, may be sharply bent, and the display module DM may be damaged.

However, when the curved portion CSPa includes the second portion PT2, the rigidity of a portion of the curved portion CSPa adjacent to the boundary between the curved portion CSPa and the first and second flat portions PLA1 and PLA2 may increase. Accordingly, when the curved portion CSPa is folded with respect to the folding axis FX, the second portion PT2 may be gently bent. Accordingly, a portion of the display module DM, which is located on the curved portion CSPa, may be gently bent, and the damage to the display module DM may be prevented.

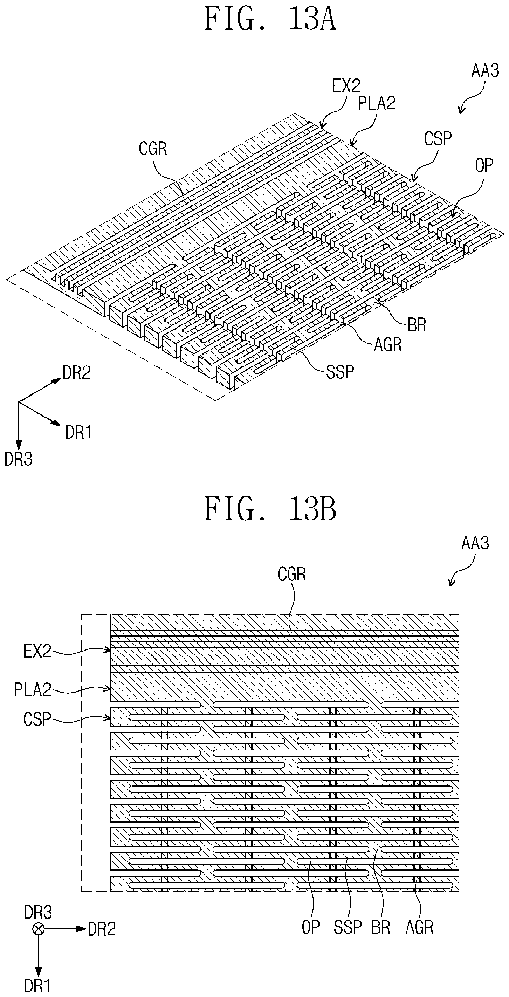

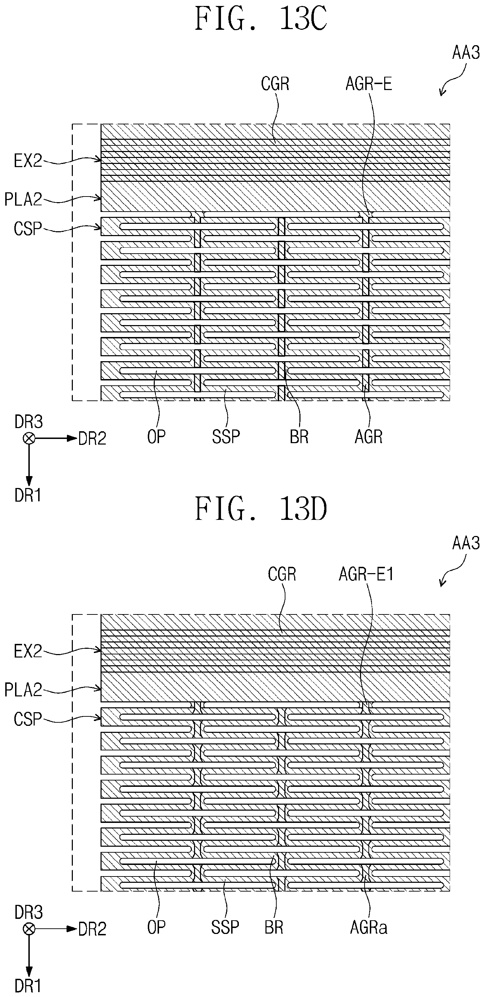

FIGS. 13A and 13B are views of a third area AA3 of a curved portion shown in FIG. 10C. FIGS. 13C and 13D are views illustrating a curved portion according to one or more embodiments of the present disclosure.

As an example, FIG. 13A is a perspective view of a portion corresponding to the third area AA3 of the folding portion PLF, and FIGS. 13B to 13D are plan views of a portion corresponding to the third area AA3.

For the convenience of explanation, FIGS. 13A to 13D illustrate the folding portion PLF that is turned upside down, and thus, a lower surface of the folding portion is shown.

Because openings OP, supporters SSP, and branches BR of FIGS. 13A to 13D are the same or substantially the same as the openings OP, the supporters SSP, and the branches BR of FIG. 10B, details thereof will be omitted or schematically described.

For the convenience for explanation, a lower surface of a curved portion CSP adjacent to a second flat portion PLA2 will be described with reference to FIGS. 13A to 13D, and descriptions of the lower surface of the curved portion CSP adjacent to the second flat portion PLA2 may be applied to a lower surface of a curved portion CSP adjacent to a first flat portion PLA1 (refer to FIG. 10C).

Referring to FIGS. 13A and 13B, air grooves AGR may be defined in the lower surface of the folding portion PLF. The air grooves AGR may be defined in the lower surface of the curved portion CSP. The air grooves AGR may be defined in at least one of the lower surface of the supporters SSP or the lower surface of the branches BR.

As an example, as shown in FIGS. 13A and 13B, the air grooves AGR may be defined in the lower surface of the supporters SSP. When viewed in the plane (or in a plan view), each of the air grooves AGR may extend in the first direction DR1 and may have a uniform width. The air grooves AGR may extend from one end of the supporters SSP to the other end of the supporters SSP opposite to the one end of the supporters SSP in the first direction DR1 via a center of the supporters SSP. The one end of the supporters SSP may be defined as a side that is opposite to the other end of the supporters SSP, which faces the second flat portion PLA2, in the first direction DR1. The center of the supporters SSP may be defined as a center between the openings adjacent to each other in the first direction DR1.

When h-th openings OP and (h+1)th openings OP are sequentially defined in the first direction DR1 going away from the second flat portion PLA2, the h-th openings OP and the (h+1)th openings OP may be connected to each other by the air grooves AGR. The air grooves AGR defined in h-th supporters SSP located between the h-th openings OP and the (h+1)th openings OP may be arranged in the second direction DR2. The air grooves AGR defined in the h-th supporters SSP and the air grooves AGR defined in (h+1)th supporters SSP may be arranged in the first direction DR1. The h is a natural number.

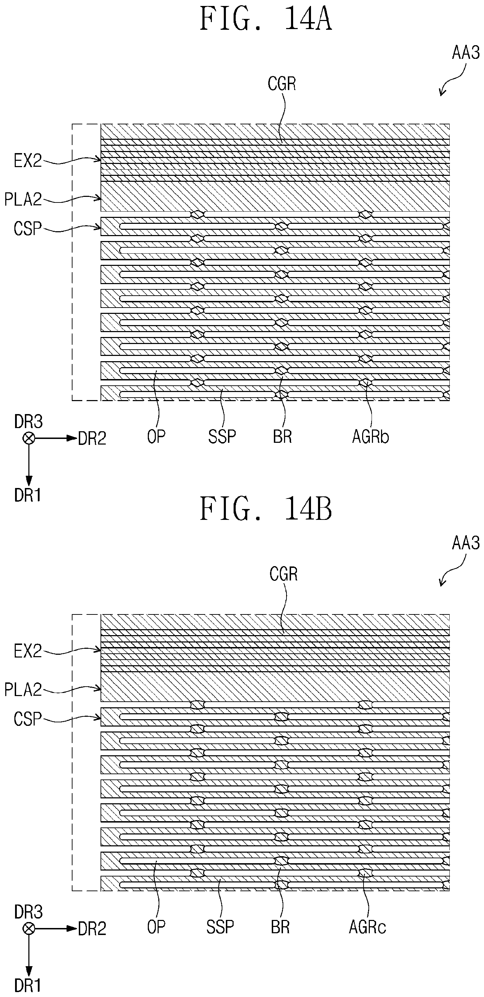

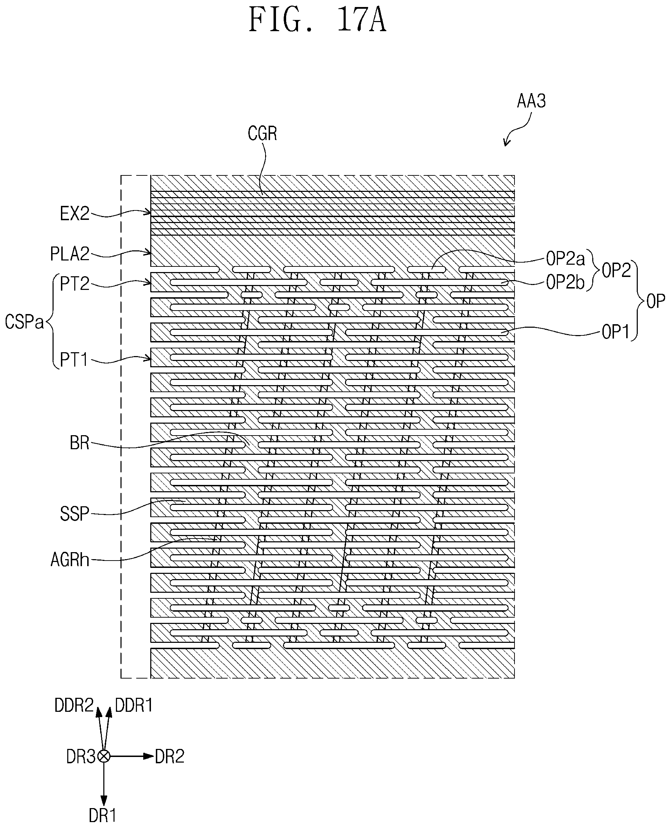

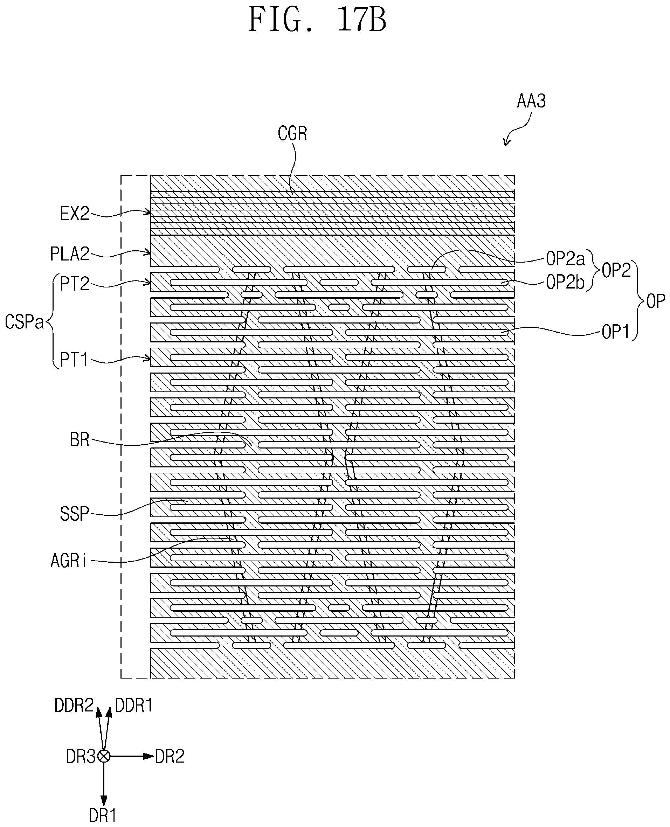

However, this is merely an example, and the direction in which the air grooves AGR defined in the h-th supporters SSP and the (h+1)th supporters SSP are arranged may be changed. This will be described in detail with reference to FIGS. 14A to 14C and FIGS. 17A and 17B.

Referring to FIGS. 9A, 13A, and 13B, when the display module DM, the barrier layer BRL, and the support plate PLT are coupled with each other, the coupling process may be performed in a vacuum state. In this case, the upper adhesive layer AL6 and the cover layer TPU may overlap the openings OP. The upper adhesive layer AL6 may cover an upper portion of the openings OP. The cover layer TPU may cover a lower portion of the openings OP. Accordingly, an interior of the openings OP may be in a vacuum state. When the coupling process is finished, the display module DM, the barrier layer BRL, and the support plate PLT may be under atmospheric pressure.

In this case, a portion of the upper adhesive layer AL6 located on the upper surface PLT-U of the support plate PLT and a portion of the cover layer TPU located on the lower surface PLT-L of the support plate PLT may be sucked into the interior of the openings OP by atmospheric or substantially atmospheric pressure. Therefore, the cover layer TPU and the upper adhesive layer AL6 may be deformed to have a shape corresponding to the pattern of the openings OP. As a result, the pattern of the openings OP may be viewed by a user from the outside of the display device DD.

However, according to at least some embodiments of the present disclosure, the air grooves AGR may be defined in the lower surface PLT-L of the support plate PLT. A passage through which air flows may be defined by the air grooves AGR.

In detail, external air may be introduced through the openings OP defined between the curved portion CSP and the second flat portion PLA2. The introduced air may flow to other openings OP through the air grooves AGR. That is, the interior of the openings OP may be filled with air at a pressure equal to, or substantially equal to atmospheric pressure. Accordingly, even though the display module DM, the barrier layer BRL, and the support plate PLT are under atmospheric pressure, the cover layer TPU and the upper adhesive layer AL6 may not be sucked into the openings OP. Accordingly, the pattern of the openings OP may be prevented from being viewed by the user by the cover layer TPU and the upper adhesive layer AL6.

According to some embodiments, the air grooves AGR may be defined in the upper surface of the supporters SSP.

Referring to FIGS. 9A and 13C, air grooves AGR may be defined in a lower surface of branches BR. The air grooves AGR may extend in the first direction DR1 in the lower surface of the branches BR. The air grooves AGR may have a uniform width in the second direction DR2. In detail, the air grooves AGR may extend from one end of the branches BR to the other end of the branches BR opposite to the one end of the branches BR in the first direction DR1 via a center of the branches BR. The one end of the branches BR may be defined as a side that is opposite to the other end of the branches BR, which faces a second flat portion PLA2, in the first direction DR1. The center of the branches BR may be defined as a center between the openings adjacent to each other in the first direction DR1.

The air grooves AGR defined in the branches BR arranged in the first direction DR1 may be arranged in the first direction DR1. Accordingly, when k-th openings OP, (k+1)th openings OP, and (k+2)th openings OP are sequentially defined in the first direction DR1 going away from the second flat portion PLA2, the k-th openings OP, (k+1)th openings OP, and the (k+2)th openings OP may be connected to each other by the air grooves AGR. The k is a natural number.

Among the air grooves AGR, the air grooves adjacent to the second flat portion PLA2 may be referred to as edge air grooves AGR-E. The edge air grooves AGR-E may extend in the first direction DR1 and the second direction DR2. The edge air grooves AGR-E may extend from the center of the branches BR to opposite sides of the branches BR in the second direction DR2. The openings OP adjacent to the edge air grooves AGR-E and adjacent to each other in the second direction DR2 may be defined consecutively with each other in the second direction DR2.

The edge air grooves AGR-E may extend to the openings OP adjacent thereto in the first direction DR1.

External air may be introduced through the openings OP adjacent to an end of a curved portion CSP. The introduced air may flow to other openings OP through the edge air grooves AGR-E and the air grooves AGR.

Accordingly, the openings OP may be filled with the air. Therefore, an upper adhesive layer AL6 located on an upper surface PLT-U of a support plate PLT and a cover layer TPU located on a lower surface PLT-L of the support plate PLT may not be sucked into the openings OP by atmospheric pressure, and as result, a pattern of the openings OP may be prevented from being viewed by the user.

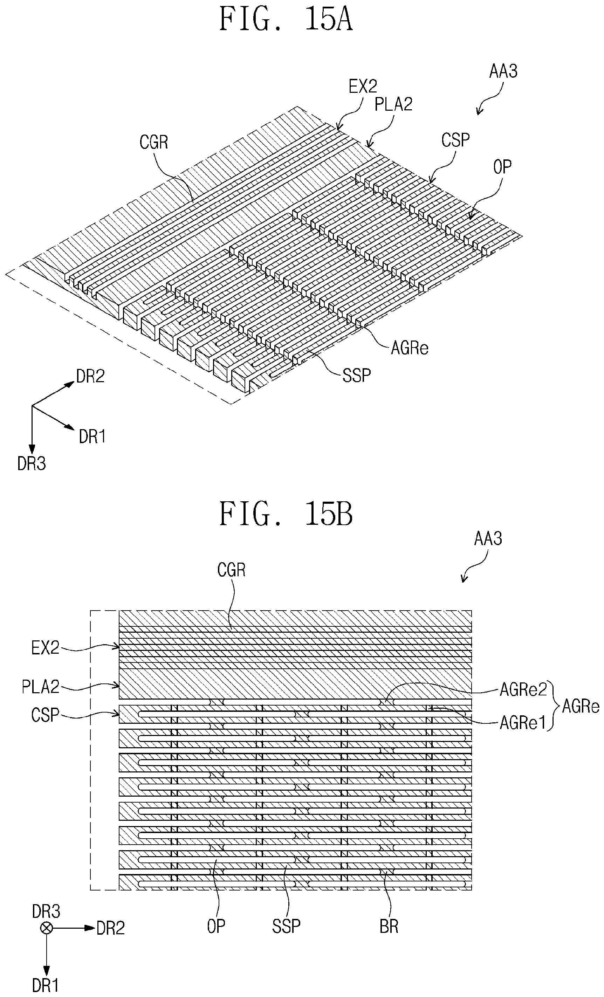

According to some embodiments, the air grooves AGR may be defined in the lower surface of the branches BR and a lower surface of the supporters SSP. This will be described in detail with reference to FIGS. 15A and 15B.

According to some embodiments, the air grooves AGR may be defined in an upper surface of the supporters SSP.

In FIG. 13D, for the convenience of explanation, the following descriptions will be focused on different features from those of FIG. 13C.

Air grooves AGRa may have a width that is not uniform in the second direction DR2. As an example, when viewed in the plane (or in a plan view), the width in the second direction DR2 of a portion of each of the air grooves AGRa adjacent to a center of branches BR may be smaller than the width in the second direction DR2 of a portion of the corresponding air grooves AGRa adjacent to opposite sides of the branches BR. Among the air grooves AGRa, the air grooves adjacent to a second flat portion PLA2 may be referred to as edge air grooves AGR-E1.

FIGS. 14A to 14C are views illustrating air grooves AGRb, AGRc, and AGRd according to one or more embodiments of the present disclosure.

As an example, FIGS. 14A to 14C are enlarged plan views illustrating a portion corresponding to the third area AA3 of FIG. 10C.

Because openings OP and supporters SSP of FIGS. 14A to 14C are the same or substantially the same as the openings OP and the supporters SSP of the FIG. 10B, details thereof will be omitted or schematically described.

Referring to FIGS. 9A, 14A, and 14B, air grooves AGRb and AGRc may be defined in a lower surface of branches BR. The air grooves AGRb and AGRc may extend in the second direction DR2 in the lower surface of the branches BR.

The openings OP adjacent to each other in the second direction DR2 may be connected to each other by the air grooves AGRb and AGRc. Accordingly, air introduced into a curved portion CSP from the outside of the curved portion CSP may flow along the air grooves AGRb and AGRc and may be filled in the openings OP. Accordingly, a cover layer TPU (refer to FIG. 9A) and an upper adhesive layer AL6 (refer to FIG. 9A) may not be sucked into the openings OP, and thus, a pattern of the openings OP may be prevented from being viewed by the user.

Referring to FIG. 14A, the air grooves AGRb may be defined in the lower surface of the branches BR when viewed in the plane (or in a plan view). The air grooves AGRb may have a width that varies in the first direction DR1. As an example, when viewed in the plane (or in a plan view), the air grooves AGRb may have a shape corresponding to a portion of a lozenge shape.

The width in the first direction DR1 of the air grooves AGRb may be the largest at a center of the branches BR. The width in the first direction DR1 of the air grooves AGRb may decrease as a distance from the center of the branches BR increases in the second direction DR2.

According to some embodiments, the air grooves AGRb may also be defined in an upper surface of the branches BR.

Referring to FIG. 14B, the air grooves AGRc may have a shape corresponding to a portion of an oval shape when viewed in the plane (or in a plan view). A width in the first direction DR1 of the air grooves AGRc may be the largest at a center of the branches BR. The width in the first direction DR1 of the air grooves AGRc may decrease from a distance from the center of the branches BR increases in the second direction DR2.

According to some embodiments, the air grooves AGRc may be defined in an upper surface of the branches BR.

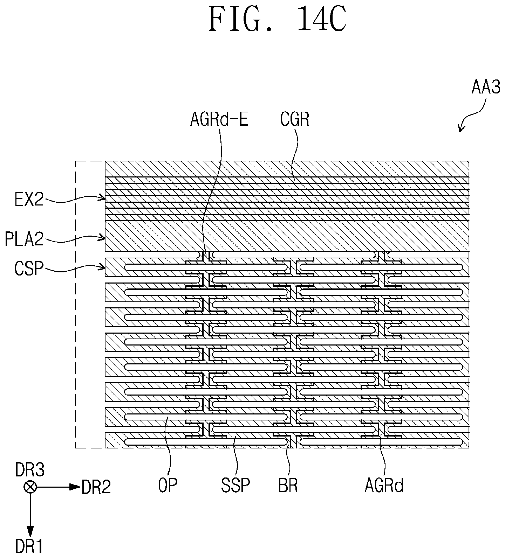

Referring to FIGS. 9A and 14C, air grooves AGRd may be defined in a lower surface of branches BR and a lower surface of the supporters SSP. When viewed in the plane (or in a plan view), the air grooves AGRd may have an H-shape rotated by about 90 degrees. The openings OP adjacent to each other in the first direction DR1 may be connected to each other by the air grooves AGRd.

Among the air grooves AGRd, the air grooves adjacent to a second flat portion PLA2 may be referred to as edge air grooves AGRd-E. The edge air grooves AGRd-E may extend in the second direction DR2 more than the air grooves AGRd, which are arranged to be spaced apart from the second flat portion PLA2, in the lower surface of the branches BR. The openings OP adjacent to opposite sides of the edge air grooves AGRd-E in the first direction DR1 may be connected to each other in the second direction DR2. Accordingly, air introduced through the opening OP adjacent to an end of a curved portion CSP may flow through the edge air grooves AGRd-E and the air grooves AGRd and may be filled in the openings OP. Accordingly, a cover layer TPU and an upper adhesive layer AL6 may not be sucked into the openings OP, and thus, a pattern of the openings OP may be prevented from being viewed by the user.

FIGS. 15A and 15B are views illustrating air grooves AGRe according to some embodiments of the present disclosure.

As an example, FIG. 15A is a perspective view of a portion corresponding to the third area AA3 of FIG. 10C, and FIG. 15B is a plan view of a portion corresponding to the third area AA3 of FIG. 10C.

Because openings OP, supporters SSP, and branches BR of FIGS. 15A and 15B are the same or substantially the same as the openings OP, the supporters SSP, and the branches BR of the FIG. 10B, details thereof will be omitted or schematically described.

Referring to FIGS. 15A and 15B, air grooves AGRe may be defined in a lower surface of the supporters SSP and a lower surface of the branches BR. The air grooves AGRe defined in the lower surface of the supporters SSP may be referred to as first air grooves AGRe1, and the air grooves AGRe defined in the lower surface of the branches BR may be referred to as second air grooves AGRe2.

When viewed in the plane (or in a plan view), the first air grooves AGRe1 may extend in the first direction DR1 with a uniform width in the second direction DR2. The first air grooves AGRe1 may extend from one end of the supporters SSP to the other end of the supporters SSP opposite to the one end of the supporters SSP in the first direction DR1. The one end of the supporters SSP may be defined as a side that is opposite to the other end of the supporters SSP, which faces a second flat portion PLA2, in the first direction DR1.

When h-th openings OP and (h+1)th openings OP are sequentially defined in the first direction DR1 going away from the second flat portion PLA2, h-th supporters SSP may be located between the h-th openings OP and the (h+1)th openings OP. The first air grooves AGRe1 defined in h-th supporters SSP may be arranged in the second direction DR2. The first air grooves AGRe1 defined in the h-th supporters SSP and the first air grooves AGRe1 defined in (h+1)th supporters SSP may be arranged in the first direction DR1. Accordingly, the h-th openings OP may be connected to the (h+1)th openings OP by the first air grooves AGRe1. The h is a natural number.

When viewed in the plane (or in a plan view), the second air grooves AGRe2 may extend in the second direction DR2. The second air grooves AGRe2 may have a shame shape. The openings OP adjacent to each other in the second direction DR2 may be connected to each other by the second air grooves AGRe2.

Referring to FIGS. 9A, 15A, and 15B, external air may be introduced through the openings OP adjacent to an end of a curved portion CSP. The air may flow through the first air grooves AGRe1 and the second air grooves AGRe2. Accordingly, the air may flow into the openings OP and may be filled in the openings OP. Thus, an upper adhesive layer AL6 located on an upper surface PLT-U of a support plate PLT and a cover layer TPU located on a lower surface PLT-L of the support plate PLT may not be sucked into the openings OP, and a pattern of the openings OP may be prevented from being viewed by the user.

According to some embodiments, the air grooves AGRe may be defined in an upper surface of the branches BR and an upper surface of the supporters SSP.

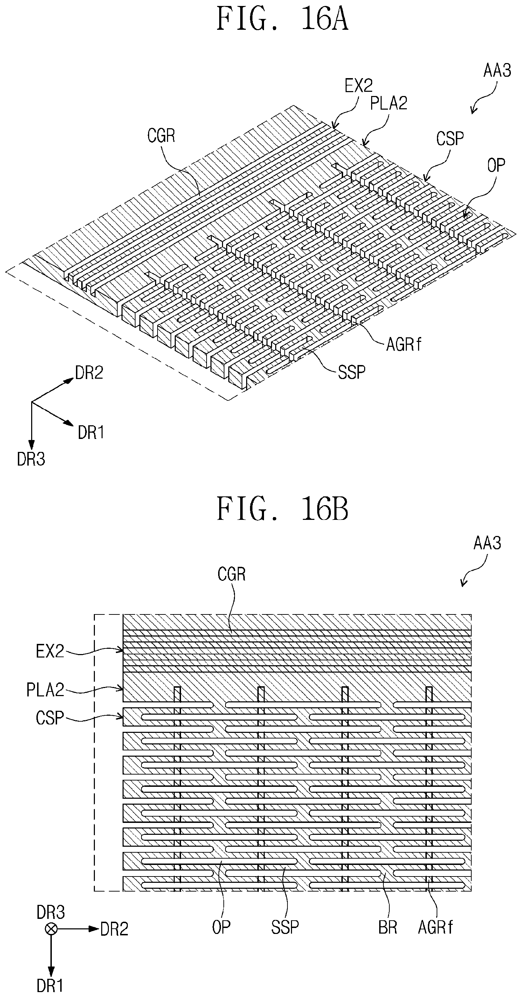

FIGS. 16A to 16C are views illustrating air grooves AGRf and AGRg according to embodiments of the present disclosure.

As an example, FIGS. 16A to 16C are views of a portion corresponding to the third area AA3 of FIG. 10C.

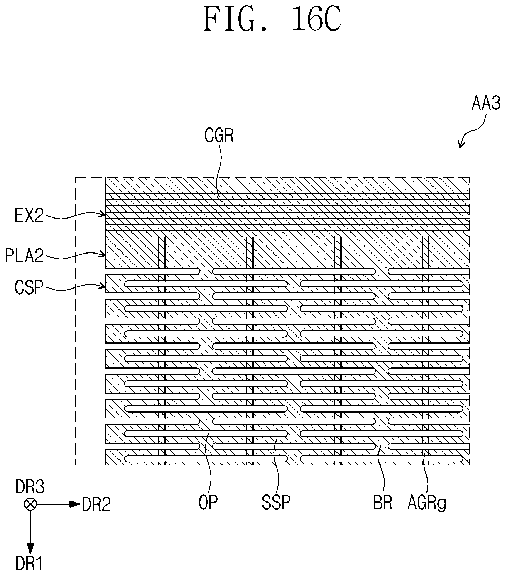

As an example, FIG. 16A is a perspective view, and FIGS. 16B and 16C are plan views.

Because a second flat portion PLA2, a second reverse curvature portion EX2, a curved portion CSP, openings OP, supporters SSP, and branches BR of FIGS. 16A to 16C are the same or substantially the same as the second flat portion PLA2, the second reverse curvature portion EX2, the curved portion CSP, the openings OP, the supporters SSP, and the branches BR of the FIG. 13A, details thereof will be omitted or schematically described.

For the convenience of explanation, in FIGS. 16A to 16C, a portion of the curved portion CSP adjacent to the second flat portion PLA2 will be described, and a portion of the curved portion CSP adjacent to a first flat portion (refer to PLA1 of FIG. 10C) may have the same or substantially the same shape as the portion of the curved portion CSP adjacent to the second flat portion PLA2.

For the convenience of explanation, the following descriptions of air grooves AGRf of FIGS. 16A and 16B and air grooves AGRg of FIG. 16C will focus on features different from those of the air grooves AGR described with reference to FIG. 13B.

Referring to FIGS. 9A, 16A, and 16B, a cover layer (refer to TPU of FIG. 9A) may be located on a lower surface of the curved portion CSP. The cover layer TPU may overlap the openings OP. A width of portions through which the openings OP are formed may be the same or substantially the same as a width of the cover layer TPU. The cover layer TPU may not be located on a lower surface of a first flat portion PLA1 and a lower surface on the second flat portion PLA2.

The air grooves AGRf may be defined in the lower surface of the second flat portion PLA2. The air grooves AGRf may extend in the first direction DR1 from one end of both ends, which are opposite to each other in the first direction DR1 of the second flat portion PLA2. The one end of the second flat portion PLA2 air grooves AGRf may be defined as a side that faces the curved portion CSP. According to some embodiments, the air grooves AGRf may extend to a lower surface of the first flat portion PLA1 (refer to FIG. 9A).

When viewed in the plane (or in a plan view), the air grooves AGRf defined in the supporters SSP arranged in the first direction DR1 and the air grooves AGRf defined in the lower surface of the second flat portion PLA2 may be arranged in the first direction DR1.

Referring to FIG. 16C, the air grooves AGRg may be defined in a lower surface of the second flat portion PLA2. The air grooves AGRg may extend in the first direction DR1 from one end of both ends, which are opposite to each other in the first direction DR1, of the second plat portion PLA2 to the other end thereof. The air grooves AGRg may be connected to a reverse curvature groove CGR defined in the lower surface of the second reverse curvature portion EX2.

When viewed in the plane (or in a plan view), the air grooves AGRg defined in the supporters SSP arranged in the first direction DR1 and the air grooves AGRg defined in the lower surface of the second flat portion PLA2 may be arranged in the first direction DR1.

Referring to FIGS. 16A to 16C, the openings OP may be connected to each other by the air grooves AGRf and AGRg. Accordingly, air introduced through opening OP defined in an end of the curved portion CSP and the air grooves AGRf and AGRg defined in the lower surface of the second flat portion PLA2 or the reverse curvature grooves CGR may flow through the air grooves AGRf and AGRg. The air may be introduced into the openings OP by the air grooves AGRf and AGRg. The air may be filled in the openings OP and the air grooves AGRf and AGRg. Accordingly, an upper adhesive layer (refer to AL6 of FIG. 9A) located on an upper surface (refer to PLT-U of FIG. 9A) of a support plate (refer to PLT of FIG. 9A) and the cover layer TPU located on a lower surface (refer to PLT-U of FIG. 9A) of the support plate PLT may not be sucked into the openings OP by atmospheric pressure, and a pattern of the openings OP may be prevented from being viewed by the user.

According to some embodiments, the air grooves AGRf and AGRg may be defined in an upper surface of the branches BR or an upper surface of the supporters SSP and may extend to an upper surface of the first and second flat portions PLA1 and PLA2 or an upper surface of the first and second reverse curvature portions EX1 and EX2.

FIGS. 17A and 17B are views illustrating air grooves AGRh and AGRi according to embodiments of the present disclosure.

As an example, FIGS. 17A and 17B are views of a portion corresponding to the third area AA3 of FIG. 10C.

Because a curved portion CSPa, a second flat portion PLA2, a second reverse curvature portion EX2, branches BR, openings OP, and supporters SSP of FIGS. 17A and 17B are the same or substantially the same as the curved portion CSPa, the second flat portion PLA2, the second reverse curvature portion EX2, the branches BR, the openings OP, and the supporters SSP of the FIG. 12B, details thereof will be omitted or schematically described.

As an example, FIGS. 17A and 17B show a structure in which air grooves AGRh and AGRi are defined in the curved portion CSPa shown in FIG. 12B, however, the air grooves AGRh and AGRi may be defined in the curved portion CSP shown in FIG. 12A.

The following descriptions of the air grooves AGRh and AGRi of FIGS. 17A and 17B will focus on features different from those of the air grooves AGR of FIG. 13B.

Referring to FIG. 17A, the air grooves AGRh may be defined in at least one of a lower surface of the branches BR or a lower surface of the supporters SSP. When viewed in the plane (or in a plan view), the air grooves AGRh may have a uniform width.

When h-th openings OP and (h+1)th openings OP are sequentially defined in the first direction DR1 going away from the second flat portion PLA2, h-th supporters SSP may be located between the h-th openings OP and the (h+1)th openings OP. The air grooves AGRh defined in the h-th supporters SSP may be arranged in the second direction DR2. The h is a natural number.

The air grooves AGRh defined in the h-th supporters SSP and the air grooves AGRh defined in (h+1)th supporters SSP may be arranged in a first diagonal direction DDR1. The openings OP may be connected to each other by the air grooves AGRh. The first diagonal direction DDR1 may be a direction forming an acute angle with a straight line parallel to the first direction DR1 in a clockwise direction, however, this is merely an example. According to some embodiments, the air grooves AGRh may be arranged in a second diagonal direction DDR2. The second diagonal direction DDR2 may be a direction forming an acute angle with the straight line parallel to the first direction DR1 in a counterclockwise direction. Hereinafter, descriptions of the air grooves AGRh are the same as described above, and thus, details thereof will be omitted.

Referring to FIG. 17B, an arrangement direction of the air grooves AGRi defined in h-th supporters SSP and the air grooves AGRi defined in (h+1)th supporters SSP may be changed at least once. As an example, the air grooves AGRi may be arranged in a straight line shape extending in the first diagonal direction DDR1 and then may be arranged in a straight line shape extending in the second diagonal direction DDR2. According to an embodiment, the air grooves AGRi may be arranged in the straight line shape extending in the second diagonal direction DDR2 and then may be arranged in a straight line shape extending in the first diagonal direction DDR1. Hereinafter, descriptions of the air grooves AGRi are the same as described above, and thus, details thereof will be omitted.

According to some embodiments, the air grooves AGRh and AGRi may be defined in at least one of an upper surface of the branches BR or an upper surface of the supporters SSP.

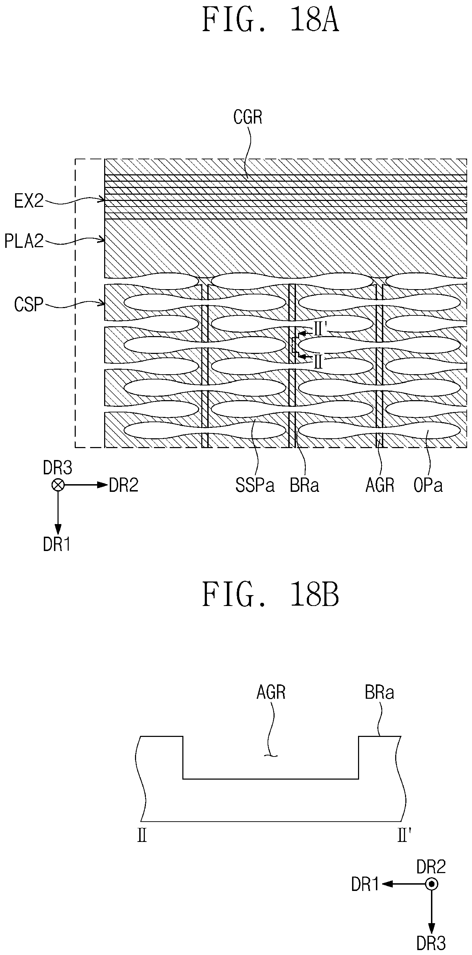

FIGS. 18A to 18D are views illustrating branches BRa and BRb and supporters SSPa and SSPb according to some embodiments of the present disclosure.

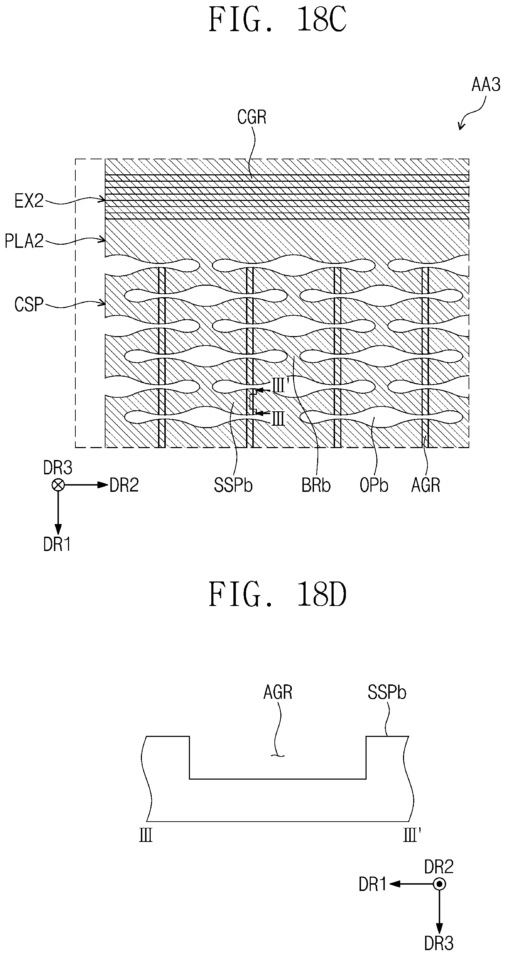

As an example, FIGS. 18A and 18C are enlarged plan views of a portion corresponding to the third area AA3 of FIG. 10C. FIG. 18B is a cross-sectional view taken along a line II-II' shown in FIG. 18A. FIG. 18D is a cross-sectional view taken along a line III-III' shown in FIG. 18C.

Because a second reverse curvature portion EX2, reverse curvature grooves CGR, a second flat portion PLA2, and air grooves AGR of FIGS. 18A and 18C are the same or substantially the same as the second reverse curvature portion EX2, the reverse curvature grooves CGR, the second flat portion PLA2, and the air grooves AGR of the FIGS. 13B and 13C, details thereof will be omitted or schematically described.

Referring to FIGS. 18A and 18B, the air grooves AGR may be defined in a lower surface of the branches BRa. The air grooves AGR may have a uniform width in the second direction DR2. When the air grooves AGR are defined in the lower surface of the branches BRa, a thickness of the branches BRa may be relatively reduced.

The branches BRa may have a rigidity that is proportional to the thickness of the branches BRa and a width of the branches BRa in the first direction DR1. As the thickness of the branches BRa is relatively reduced by the air grooves AGR, the rigidity of the branches BRa may be relatively reduced.

However, the reduction in thickness of the branches BRa according to the present disclosure may be compensated for by increasing the width in the first direction DR1 of the branches BRa. That is, when viewed in the plane (or in a plan view), opposite ends in the first direction DR1 of the branches BRa may protrude to openings OPa adjacent to each other in the first direction DR1. The opposite ends in the first direction DR1 of the branches BRa may have a shape convex toward the openings OPa adjacent to each other in the first direction DR1. The openings OPa may have a shape corresponding to the opposite ends of the branches BRa. The opposite ends in the first direction DR1 of the supporters SSPa may have a concave shape. As an example, the openings OPa may have a dumbbell shape.

Accordingly, even though the air grooves AGR are defined in the lower surface of the branches BRa, the width in the first direction DR1 of the branches BRa may increase, and thus, the rigidity of the branches BRa may be prevented from being relatively reduced. Thus, even though a curved portion CSP is folded or unfolded, the branches BRa may not be deformed.

According to some embodiments, the air grooves AGR may be defined in an upper surface of the branches BRa.

Referring to FIGS. 18C and 18D, the air grooves AGR may be defined in a lower surface of supporters SSPb. The air grooves AGR may have a uniform width in the second direction DR2. When the air grooves AGR are defined in the lower surface of the supporters SSPb, a thickness of the supporters SSPb may be relatively reduced.

The supporters SSPb may have a rigidity that is proportional to the thickness of the supporters SSPb and a width in the first direction DR1 of the supporters SSPb. As the thickness of the supporters SSPb is relatively reduced by the air grooves AGR, the rigidity of the supporters SSPb may be relatively reduced.

The reduction in thickness of the supporters SSPb may be compensated for by increasing the width in the first direction DR1 of the supporters SSPb. That is, when viewed in the plane (or in a plan view), opposite ends in the first direction DR1 of the supporters SSPb may protrude to openings OPb adjacent to each other in the first direction DR1. The opposite ends in the first direction DR1 of the supporters SSPb may have a shape convex toward the openings OPb adjacent to each other in the first direction DR1. Opposite ends in the first direction DR1 of the branches BRb may have a concave shape.

Accordingly, even though the air grooves AGR are defined in the lower surface of the supporters SSPb, the width in the first direction DR1 of the supporters SSPb may increase, and thus, the rigidity of the supporters SSPb may be prevented from being reduced. Thus, even though a curved portion CSP is folded or unfolded, the supporters SSPb may not be deformed.

According to some embodiments, the air grooves AGR may be defined in an upper surface of the supporters SSPb.

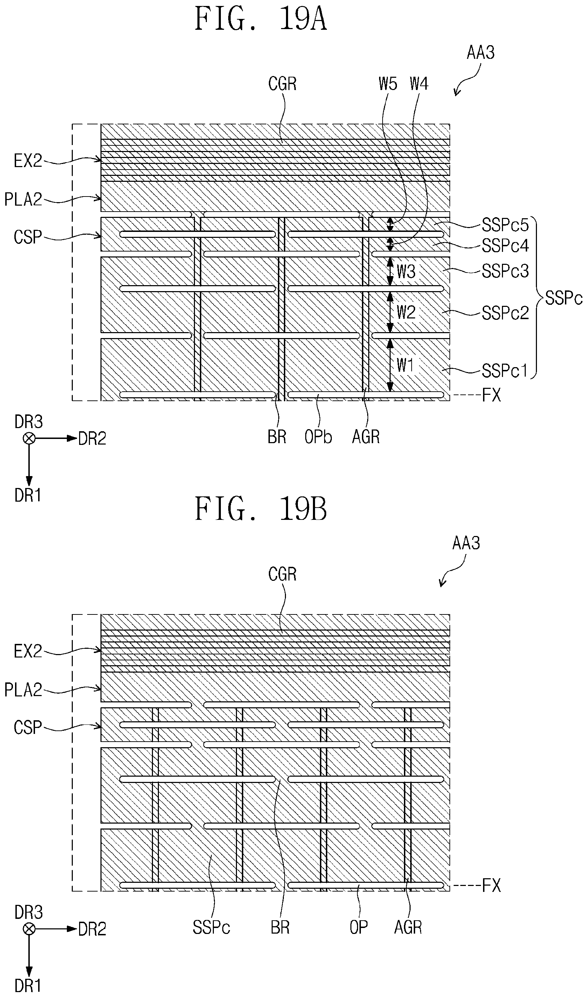

FIGS. 19A and 19B are views illustrating supporters SSPc according to embodiments of the present disclosure.

As an example, FIGS. 19A and 19B are plan views of a portion corresponding to the third area AA3 of FIG. 10C.

Because branches BR, openings OP, and air grooves AGR of FIGS. 19A and 19B are the same or substantially the same as the branches BR, the openings OP, and the air grooves AGR of the FIGS. 13B and 13C, details thereof will be omitted or schematically described.

For the convenience of explanation, descriptions with reference to FIG. 19B will focus on features different from those of FIG. 19A.

For the convenience of explanation, supporters SSPc located between a folding axis FX and a second flat portion PLA2 will be described in FIGS. 19A and 19B, and supporters SSPc located between the folding axis FX and a first flat portion PLA1 may have the same or substantially the same structure.

Referring to FIG. 19A, the folding axis FX may overlap the openings OP. A portion of a curved portion CSP, which overlaps the folding axis FX, may be defined as a center of the curved portion CSP. The supporters SSPc may be located between the openings OP spaced apart from each other in the first direction DR1. As an example, the supporters SSPc may include a first supporter SSPc1, a second supporter SSPc2, a third supporter SSPc3, a fourth supporter SSPc4, and a fifth supporter SSPc5 in order away from the folding axis FX, however, this is merely an example, and the number of the supporters SSPc should not be limited thereto or thereby.

The air grooves AGR may be defined in a lower surface of the supporters SSPc and the lower surface of the branches BR. The air grooves AGR may extend in the first direction DR1. The air grooves AGR may have a uniform width in the second direction DR2. The air grooves AGR may be extend along the first direction DR1 from one end of the supporters SSPc to the other end of the supporters SSPc, which is opposite to the one end in the first direction DR1. The one end of opposite ends of the supporters SSPc may be defined as a side that is opposite to the other side, which faces the second flat portion PLA2.

When the curved portion CSP is folded, a stress applied to the curved portion CSP may increase as a distance from the folding axis FX decreases. Accordingly, the supporters SSPc adjacent to the folding axis FX may be required to have a high rigidity. The rigidity may be proportional to a thickness of the supporters SSPc and a width in the first direction DR1 of the supporters SSPc.

As the air grooves AGR are defined in the lower surface of the supporters SSPc, the thickness of the supporters SSPc is relatively reduced, and the rigidity of the supporters SSPc adjacent to the folding axis FX may be relatively reduced. When the rigidity is relatively reduced, the supporters SSPc adjacent to the folding axis FX may be deformed by repeated folding and unfolding operations.

However, the width in the first direction DR1 of the supporters SSPc may be varied. In detail, the width in the first direction DR1 of the first supporters SSPc1 adjacent to the folding axis FX may be referred to as a first width W1. The width in the first direction DR1 of the second supporters SSPc2 may be referred to as a second width W2. The width in the first direction DR1 of the third supporters SSPc3 may be referred to as a third width W3. The width in the first direction DR1 of the fourth supporters SSPc4 may be referred to as a fourth width W4. The width in the first direction DR1 of the fifth supporters SSPc5 may be referred to as a fifth width W5.

The first width W1 may be greater than the second width W2. The second width W2 may be greater than the third width W3. The third width W3 may be greater than the fourth width W4. The fourth width W4 may be greater than the fifth width W5. As a distance from the folding axis FX increases, a distance between the openings OP adjacent to each other in the first direction DR1 may decrease.

Accordingly, even though the air grooves AGR are defined in the lower surface of the supporters SSPc adjacent to the folding axis FX and a thickness of the supporters SSPc is relatively reduced, the reduction in thickness of the supporters SSPc may be compensated for by increasing the width in the first direction DR1 of the supporters SSPc. Therefore, the first supporters SSPc1 adjacent to the folding axis FX may have the highest rigidity among the supporters SSPc, and thus, the supporters SSPc adjacent to the folding axis FX may not be deformed even though the curved portion CSP is repeatedly folded and unfolded.

Referring to FIG. 19B, the supporters SSPc shown in FIG. 19B may have the same or substantially the same structure as those shown in FIG. 19A except that the air grooves AGR are defined only in a lower surface of the supporters SSPc, and thus, details thereof will be omitted.

According to some embodiments, the air grooves AGR may be defined in an upper surface of the supporters SSPc.

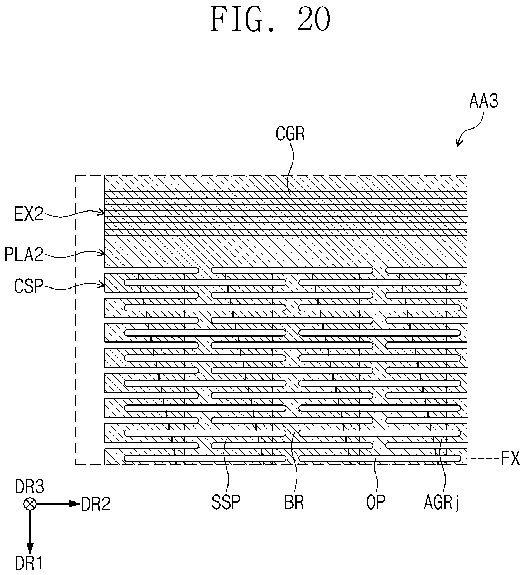

FIG. 20 is a view illustrating air grooves AGRj according to some embodiments of the present disclosure.

As an example, FIG. 20 is an enlarged plan view of a portion corresponding to the third area AA3 of FIG. 10C.

Because a second reverse curvature portion EX2, a second flat portion PLA2, a curved portion CSP, branches BR, supporters SSP, and openings OP of FIG. 20 are the same or substantially the same as the second reverse curvature portion EX2, the second flat portion PLA2, the curved portion CSP, the branches BR, the supporters SSP, and the openings OP of the FIG. 13B, details thereof will be omitted or schematically described.

Referring to FIG. 20, the air grooves AGRj may be defined in a lower surface of the supporters SSP. When h-th openings OP and (h+1)th openings OP are sequentially arranged in the first direction going from the second flat portion PLA2 to a folding axis, h-th supporters SSP located between the h-th openings OP and the (h+1)th openings OP may be arranged in the second direction DR2. The air grooves AGRj defined in the h-th supporters SSP may have the same width in the second direction DR2. The h is a natural number.

The air grooves AGRj defined in the h-th supporters SSP and the air grooves AGRj defined in (h+1)th supporters SSP may be arranged in the first direction DR1. A width in the second direction DR2 of the air grooves AGRj defined in the h-th supporters SSP may be greater than the width in the second direction DR2 of the air grooves AGRj defined in the (h+1)th supporters SSP.

According to some embodiments, the air grooves AGRj defined in the curved portion CSP adjacent to the first flat portion PLA1 and the air grooves AGRj defined in the curved portion CSP adjacent to the second flat portion PLA2 are symmetrical with each other based on the folding axis FX.

As a distance from the folding axis FX increases, a size in the second direction DR2 of the air grooves AGRj may increase. That is, the air grooves AGRj adjacent to the second flat portion PLA2 may have the largest size in the second direction DR2, and the air grooves AGRj adjacent to the folding axis FX may have the smallest size in the second direction DR2.

The supporters SSP may have a rigidity that is proportional to a thickness of the supporters SSP and a width in the first direction DR1 of the supporters SSP and inverse proportional to a length in the second direction DR2 of the supporters SSP. When the air grooves AGRj are defined in a lower surface of the supporters SSP, the rigidity of portions of the supporters SSP, which define the air grooves AGRj, may be relatively reduced. The rigidity of the supporters SSP may be determined by a sum of the rigidity of the supporters SSP that overlap the air grooves AGRj and the rigidity of the supporters SSP that do not overlap the air grooves AGRj.

When the curved portion CSP is folded, a tensile force applied to the supporters SSP may increase as a distance from the folding axis FX decreases. The supporters SSP adjacent to the folding axis FX may be required to have a large rigidity to prevent the supporters SSP from being deformed.

When the air grooves AGRj are defined in the lower surface of the supporters SSP, the width in the second direction DR2 of the air grooves AGRj may be relatively reduced to prevent the rigidity of the supporters SSP adjacent to the folding axis FX from being reduced. Accordingly, the length of the supporters SSP overlapping the air grooves AGRj may decrease, and thus, the rigidity of the supporters SSP may be prevented from being reduced. Thus, even though the curved portion CSP is folded and unfolded, the supporters SSP may be prevented from being deformed.

According to some embodiments, the air grooves AGRj may be defined in an upper surface of the curved portion CSP.

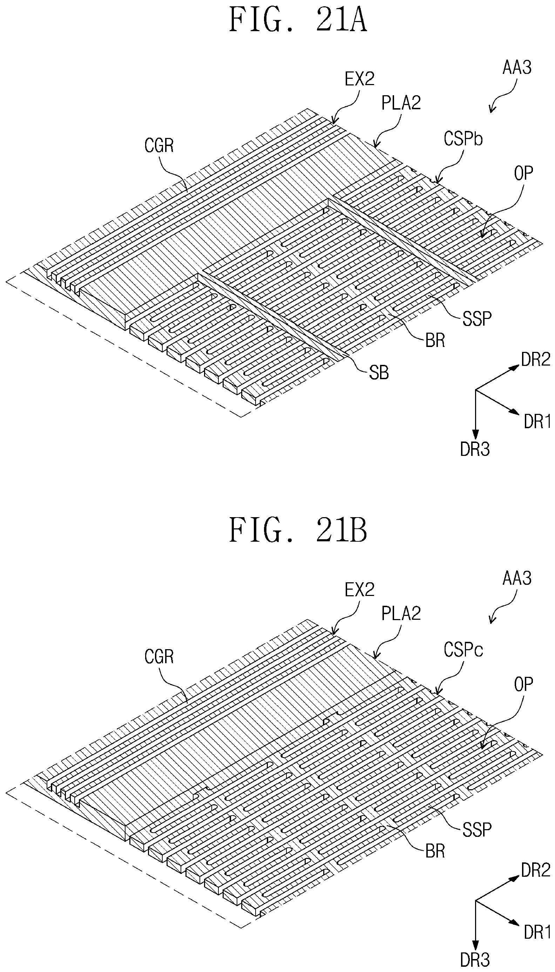

FIGS. 21A and 21B are views illustrating curved portions CSPb and CSPc according to embodiments of the present disclosure.

As an example, FIGS. 21A and 21B are perspective views of a portion corresponding to the third area AA3 of FIG. 10C.

Because a second reverse curvature portion EX2 and a second flat portion PLA2 of FIGS. 21A and 21B are the same or substantially the same as the second reverse curvature portion EX2 and the second flat portion PLA2 of the FIG. 13B, details thereof will be omitted or schematically described.

For the convenience of explanation, descriptions of the curved portion of FIG. 21B will focus on different features from those of the curved portion of FIG. 21A.

Referring to FIGS. 9A and 21A, a lower surface of the curved portion CSPb and a lower surface of the second flat portion PLA2 may be arranged to form a step difference therebetween. According to some embodiments, the lower surface of the curved portion CSPb and a lower surface of a first flat portion PLA1 may be arranged to form a step difference therebetween. When the support plate PLT is located under the display module DM, a height of the lower surface of the curved portion CSPb may be greater than a height of the lower surface of the first flat portion PLA1 and the lower surface of the second flat portion PLA2.

The curved portion CSPb may include a plurality of support bars SB. The support bars SB may be located on a lower surface of branches. The support bars SB may extend in the first direction DR1 and may be arranged in the second direction DR2. As another example, the support bars SB may be located on a lower surface of supporters SSP.

A cover layer TPU may be located on a lower surface of the support bars SB and the lower surfaces of the first and second flat portions PLA1 and PLA2. The cover layer TPU may be spaced apart from the lower surface of the branches BR and the lower surface of the supporters SSP. The cover layer TPU may be arranged to not cover a lower side of openings OP.

The openings OP may be defined to be continued from a space between the lower surface of the branches BR and the cover layer TPU and a space between the lower surface of the supporters SSP and the cover layer TPU along the third direction DR3. Accordingly, external air may be introduced into the openings OP. The openings OP may not be in a vacuum state. Therefore, the cover layer TPU and an upper adhesive layer AL6 may be prevented from being sucked into the openings OP, and thus, a pattern of the openings OP may be prevented from being viewed from the outside.

Referring to FIG. 21B, a lower surface of the curved portion CSPc and a lower surface of the second flat portion PLA2 may be arranged to form a step difference therebetween. According to some embodiments, the lower surface of the curved portion CSPc and a lower surface of the first flat portion PLA1 (refer to FIG. 9A) may be arranged to form a step difference therebetween. When the support plate PLT (refer to FIG. 9A) is located under the display module DM (refer to FIG. 9A), a height of the curved portion CSPc may be greater than a height of the lower surface of the first flat portion PLA1 and the lower surface of the second flat portion PLA2.

The curved portion CSPc may not include support bars (refer to SB of FIG. 21A). In this case, a width in the first direction DR1 of the cover layer TPU (refer to FIG. 9A) may be greater than a width in the first direction DR1 of the curved portion CSPc. The cover layer TPU may be located on the lower surface of the first flat portion PLA1 and the lower surface of the second flat portion PLA2. An upper surface of the cover layer TPU may be spaced apart from the lower surface of the curved portion CSPc. The cover layer TPU may be arranged to not cover a lower side of openings OP. A space may be defined by the upper surface of the cover layer TPU and the lower surface of the curved portion CSPc. The openings OP may be formed to be continued from the space defined by the upper surface of the cover layer TPU and the lower surface of the curved portion CSPc.

Accordingly, external air may be introduced into the openings OP and may prevent the openings OP from being in a vacuum state. Thus, the cover layer TPU and an upper adhesive layer AL6 may be prevented from being sucked into the openings OP, and thus, a pattern of the openings OP may be prevented from being viewed from the outside.

Although aspects of some embodiments of the present disclosure have been described, it is understood that the present disclosure should not be limited to these embodiments but various changes and modifications can be made by one ordinary skilled in the art within the scope of the present disclosure as hereinafter claimed. Therefore, the disclosed subject matter should not be limited to any single embodiment described herein, and the scope of the present inventive concept shall be determined according to the attached claims, and their equivalents.

Embodiments are set out in the following clauses:
Clause 1. A display device comprising:
   a display panel comprising a first non-folding area, a folding area, and a second non-folding area, which are arranged in a first direction;
   a support plate under the display panel and having a plurality of openings that overlaps the folding area;
   an upper adhesive layer between the display panel and the support plate and overlapping the openings; and
   a cover layer overlapping the openings and under the support plate, the support plate comprising:
      a plurality of supporters between the openings adjacent to each other in the first direction; and
      a plurality of branches between the openings adjacent to each other in a second direction intersecting the first direction, wherein the openings are defined by the branches and the supporters, and at least one of a lower surface of the branches or a lower surface of the supporters is provided with a plurality of air grooves defined therein.
Clause 2. The display device of clause 1, wherein the air grooves extend in the first direction in a plan view, and the air grooves defined in the branches arranged in the first direction are arranged in the first direction.
Clause 3. The display device of clause 2, wherein the air grooves extend to both ends opposite to each other in the first direction of the branches from a center of the branches in the plan view.
Clause 4. The display device of clause 3, wherein a width in the second direction of the air grooves adjacent to the both ends of the branches is greater than a width in the second direction of the air grooves adjacent to the center of the branches in the plan view.
Clause 5. The display device of clause 3, wherein the air grooves have a uniform width, and the both ends opposite to each other in the first direction of the branches protrude toward the openings adjacent thereto in the first direction in the plan view.
Clause 6. The display device of any of clauses 1 to 5, wherein, in a plan view, the air grooves are defined in a lower surface of the supporters, the air grooves extend to both ends opposite to each other in the first direction of the supporters from a center of the supporters, and the air grooves defined in the supporters arranged in the first direction are arranged in the first direction.
Clause 7. The display device of clause 6, wherein the air grooves have a uniform width, and the both ends opposite to each other in the first direction of the supporters protrude toward the openings adjacent thereto in the first direction.
Clause 8. The display device of clause 6 or clause 7, wherein the air grooves are further defined in the lower surface of the branches, the air grooves defined in the supporters are defined as first air grooves, the air grooves defined in the branches are defined as second air grooves, and the second air grooves extend in the second direction.
Clause 9. The display device of any of clauses 2 to 8, wherein a portion of the support plate, which overlaps the first non-folding area, is defined as a first non-folding portion, a portion of the support plate, which overlaps the second non-folding area, is defined as a second non-folding portion, a portion of the support plate, which overlaps the folding area, is defined as a folding portion, and the folding portion comprises:
   a curved portion through which the openings are defined;
   a first reverse curvature portion between the curved portion and the first non-folding portion;
   a second reverse curvature portion between the curved portion and the second non-folding portion;
   a first flat portion between the first reverse curvature portion and the curved portion; and
   a second flat portion between the second reverse curvature portion and the curved portion.
Clause 10. The display device of clause 9, wherein the cover layer is on a lower surface of the curved portion, and the air grooves extend to the first flat portion and the second flat portion.
Clause 11. The display device of clause 10, wherein the air grooves extend to the first reverse curvature portion and the second reverse curvature portion in the first direction.
Clause 12. The display device of any of clauses 9 to 11, wherein the folding area is folded or unfolded with respect to a folding axis that extends in the second direction, the curved portion comprises:
   a first portion overlapping the folding axis; and
   a plurality of second portions between the first portion and the first flat portion and between the first portion and the second flat portion, and a size ratio of the openings to the branches is relatively smaller in the second portion than in the first portion.
Clause 13. The display device of any of clauses 9 to 12, wherein a plurality of reverse curvature grooves is arranged in a lower surface of the first reverse curvature portion and a lower surface of the second reverse curvature portion along the first direction, and the reverse curvature grooves extend in the second direction.
Clause 14. The display device of any of clauses 9 to 13, wherein a distance between the openings adjacent to each other in the first direction is greater in a center of the curved portion than in a portion of the curved portion, which is adjacent to the first flat portion and the second flat portion.
Clause 15. The display device of any of clauses 2 to 14, wherein a portion of the support plate, which overlaps the first non-folding area, is defined as a first non-folding portion, a portion of the support plate, which overlaps the second non-folding area, is defined as a second non-folding portion, a portion of the support plate, which overlaps the folding area, is defined as a folding portion, and a width in the second direction of the air grooves is greater in the portions of the folding portion, which are adjacent to the first and second non-folding portions, than in a center of the folding portion.
Clause 16. The display device of any of clauses 1 to 15, wherein the air grooves extend in the second direction in the lower surface of the branches in a plan view, and a width in the first direction of the air grooves is varied.
Clause 17. The display device of any of clauses 1 to 16, wherein, in a plan view, the air grooves extend in the first direction, the air grooves defined in the supporters arranged in the first direction are arranged in a first diagonal direction or a second diagonal direction, the first diagonal direction is a direction forming an acute angle with the first direction in a clockwise direction, and the second diagonal direction is a direction forming an acute angle with the first direction in a counterclockwise direction.
Clause 18. The display device of clause 17, wherein an arrangement direction of the air grooves defined in the supporters arranged in the first direction is changed at least once in the plan view.
Clause 19. A display device comprising:
   a display panel;
   a support plate under the display panel and comprising a first non-folding portion, a folding portion, and a second non-folding portion, which are arranged in a first direction;
   an upper adhesive layer between the display panel and the folding portion; and
   a cover layer on a lower surface of the folding portion, the folding portion comprising:
      a curved portion through which a plurality of openings arranged in the first direction and a second direction intersecting the first direction is defined;
      a first flat portion between the first non-folding portion and the curved portion; and
      a second flat portion between the second non-folding portion and the curved portion, wherein the cover layer is on a lower surface of the first and second flat portions, and a height of a lower surface of the curved portion is greater than a height of the lower surface of the first and second flat portions.
Clause 20. The display device of clause 19, wherein the curved portion comprises:
   a plurality of supporters between the openings adjacent to each other in the first direction; and
   a plurality of branches between the openings adjacent to each other in the second direction.
Clause 21. The display device of clause 20, wherein the curved portion further comprises a plurality of support bars in a lower surface of the branches, extending in the first direction, and arranged in the second direction, and the cover layer is on a lower surface of the support bars.

## Claims

1. A display device comprising:
a display panel comprising a first non-folding area, a folding area, and a second non-folding area, which are arranged in a first direction;
a support plate under the display panel and having a plurality of openings that overlaps the folding area;
an upper adhesive layer between the display panel and the support plate and overlapping the openings; and
a cover layer overlapping the openings and under the support plate, the support plate comprising:
a plurality of supporters between the openings adjacent to each other in the first direction; and
a plurality of branches between the openings adjacent to each other in a second direction intersecting the first direction, wherein the openings are defined by the branches and the supporters, and at least one of a lower surface of the branches or a lower surface of the supporters is provided with a plurality of air grooves defined therein.

2. The display device of claim 1, wherein the air grooves extend in the first direction in a plan view, and the air grooves defined in the branches arranged in the first direction are arranged in the first direction.

3. The display device of claim 2, wherein the air grooves extend to both ends opposite to each other in the first direction of the branches from a center of the branches in the plan view.

4. The display device of claim 3, wherein a width in the second direction of the air grooves adjacent to the both ends of the branches is greater than a width in the second direction of the air grooves adjacent to the center of the branches in the plan view; or
wherein the air grooves have a uniform width, and the both ends opposite to each other in the first direction of the branches protrude toward the openings adjacent thereto in the first direction in the plan view.

5. The display device of any of claims 1 to 4, wherein, in a plan view, at least some of the air grooves are defined in a lower surface of the supporters, the air grooves extend to both ends opposite to each other in the first direction of the supporters from a center of the supporters, and the air grooves defined in the supporters arranged in the first direction are arranged in the first direction.

6. The display device of claim 5, wherein the air grooves of the lower surface of the supporters have a uniform width, and the both ends opposite to each other in the first direction of the supporters protrude toward the openings adjacent thereto in the first direction.

7. The display device of claim 5 or claim 6, wherein the air grooves are defined in the lower surface of the supporters and the lower surface of the branches, the air grooves defined in the supporters are defined as first air grooves, the air grooves defined in the branches are defined as second air grooves, and the second air grooves extend in the second direction.

8. The display device of any of claims 1 to 7, wherein a portion of the support plate, which overlaps the first non-folding area, is defined as a first non-folding portion, a portion of the support plate, which overlaps the second non-folding area, is defined as a second non-folding portion, a portion of the support plate, which overlaps the folding area, is defined as a folding portion, and the folding portion comprises:
a curved portion through which the openings are defined;
a first reverse curvature portion between the curved portion and the first non-folding portion;
a second reverse curvature portion between the curved portion and the second non-folding portion;
a first flat portion between the first reverse curvature portion and the curved portion; and
a second flat portion between the second reverse curvature portion and the curved portion.

9. The display device of claim 8, wherein the cover layer is on a lower surface of the curved portion, and the air grooves extend to the first flat portion and the second flat portion; optionally:
wherein the air grooves extend to the first reverse curvature portion and the second reverse curvature portion in the first direction.

10. The display device of claim 8 or claim 9, wherein the folding area is configured to be folded or unfolded with respect to a folding axis that extends in the second direction, the curved portion comprises:
a first portion overlapping the folding axis; and
a plurality of second portions between the first portion and the first flat portion and between the first portion and the second flat portion, and a size ratio of the openings to the branches is relatively smaller in the second portion than in the first portion.

11. The display device of any of claims 8 to 10, wherein a plurality of reverse curvature grooves is arranged in a lower surface of the first reverse curvature portion and a lower surface of the second reverse curvature portion along the first direction, and the reverse curvature grooves extend in the second direction; and/or
wherein a distance between the openings adjacent to each other in the first direction is greater in a center of the curved portion than in a portion of the curved portion, which is adjacent to the first flat portion and the second flat portion.

12. The display device of any preceding claim, wherein a portion of the support plate, which overlaps the first non-folding area, is defined as a first non-folding portion, a portion of the support plate, which overlaps the second non-folding area, is defined as a second non-folding portion, a portion of the support plate, which overlaps the folding area, is defined as a folding portion, and a width in the second direction of the air grooves is greater in the portions of the folding portion, which are adjacent to the first and second non-folding portions, than in a center of the folding portion; and/or
wherein at least some of the air grooves extend in the second direction in the lower surface of the branches in a plan view, and a width in the first direction of the at least some air grooves in the lower surface of the branches is varied.

13. The display device of any preceding claim, wherein, in a plan view, at least some of the air grooves extend in the first direction, at least some of the air grooves defined in the supporters arranged in the first direction are arranged in a first diagonal direction or a second diagonal direction, the first diagonal direction is a direction forming an acute angle with the first direction in a clockwise direction, and the second diagonal direction is a direction forming an acute angle with the first direction in a counterclockwise direction; optionally:
wherein an arrangement direction of the air grooves defined in the supporters arranged diagonally in the first direction is changed at least once in the plan view.

14. A display device comprising:
a display panel;
a support plate under the display panel and comprising a first non-folding portion, a folding portion, and a second non-folding portion, which are arranged in a first direction;
an upper adhesive layer between the display panel and the folding portion; and
a cover layer on a lower surface of the folding portion, the folding portion comprising:
a curved portion through which a plurality of openings arranged in the first direction and a second direction intersecting the first direction is defined;
a first flat portion between the first non-folding portion and the curved portion; and
a second flat portion between the second non-folding portion and the curved portion, wherein the cover layer is on a lower surface of the first and second flat portions, and a height of a lower surface of the curved portion is greater than a height of the lower surface of the first and second flat portions.

15. The display device of claim 14, wherein the curved portion comprises:
a plurality of supporters between the openings adjacent to each other in the first direction; and
a plurality of branches between the openings adjacent to each other in the second direction; optionally:
wherein the curved portion further comprises a plurality of support bars in a lower surface of the branches, extending in the first direction, and arranged in the second direction, and the cover layer is on a lower surface of the support bars.
